(19) Europäisches Patentamt
European Patent Office
Office européen des brevets

(11) **EP 1 854 863 A1**

(12) **EUROPEAN PATENT APPLICATION**
published in accordance with Art. 158(3) EPC

(43) Date of publication:
**14.11.2007 Bulletin 2007/46**

(51) Int Cl.:
*C09K 11/62* [(2006.01)]    *C09K 11/78* [(2006.01)]
*C09K 11/80* [(2006.01)]    *C09K 11/08* [(2006.01)]
*H01L 33/00* [(2006.01)]

(21) Application number: 06714419.6

(22) Date of filing: **23.02.2006**

(86) International application number:
**PCT/JP2006/303279**

(87) International publication number:
**WO 2006/093015 (08.09.2006 Gazette 2006/36)**

(84) Designated Contracting States:
**DE**

(30) Priority: **28.02.2005   JP 2005053676**

(71) Applicant: **Mitsubishi Chemical Corporation**
**Minato-ku**
**Tokyo 108-0014 (JP)**

(72) Inventors:
• **SHIMIZU, Etsuo**
  **Mitsubishi Chem. Group**
  **Aoba-ku, Yokohama-shi, Kanagawa (JP)**

• **YOSHINO, Masahiko**
  **Mitsubishi Chem. Group**
  **Aoba-kum Yokohama-shi, Kanagawa (JP)**
• **KIJIMA, Naoto**
  **Mitsubishi Chem. Group**
  **Aoba-ku, Yokohama-shi, Kanagawa (JP)**

(74) Representative: **HOFFMANN EITLE**
**Patent- und Rechtsanwälte**
**Arabellastrasse 4**
**81925 München (DE)**

(54) **PHOSPHOR AND METHOD FOR PRODUCTION THEREOF, AND APPLICATION THEREOF**

(57)    A phosphor containing a crystal phase having a chemical composition expressed by the following general formula [1], and exhibiting an average variation rate of the emission intensity of 1.3 or less upon excitation with light having a peak in the wavelength range of 420 nm to 480 nm, the variation rate of the emission intensity being calculated by the following general formula [2].

$$(Ln_{1-a-b}Ce_aTb_b)_3M_5O_{12} \qquad [1]$$

wherein Ln is at least one element selected from the group consisting of Y, Gd, Sc, Lu, and La, M represents at least one element selected from the group consisting of A1, Ga, and In, and a and b satisfy $0.001 \leq a \leq 0.3$ and $0 \leq b \leq 0.5$, respectively.

$$\text{Variation rate of emission intensity} = [(I(\lambda + 1) - I(\lambda))/I(\lambda)]^2 \quad [2]$$

wherein $I(\lambda)$ is the emission intensity of the phosphor at an excitation wavelength of $\lambda$ nm, and $I(\lambda + 1)$ is the emission intensity of the phosphor at an excitation wavelength of $(\lambda + 1)$ nm.

EP 1 854 863 A1

Fig. 1

**Description**

Technical Field

The present invention relates to a phosphor which emits yellow fluorescence, a method of producing the same, a phosphor-containing composition and a light-emitting device including the phosphor, and an image display device and a lighting system including the light-emitting device. More specifically, the present invention relates to an yellow phosphor which stably emits light, a method of producing the same, a phosphor-containing composition and a light-emitting device including the phosphor, and an image display device and a lighting system including the light-emitting device.

Background Art

Semiconductor light-emitting elements such as a light-emitting diode (LED) and a laser diode (LD) which emit light in the visible to ultraviolet region have been developed. Display devices composed of such semiconductor light-emitting elements various colors of are used as displays or traffic signals. In addition, a light-emitting device which converts the luminescent color of a semiconductor light-emitting element with a phosphor has been proposed.

In recent years, a white light-emitting device composed of a gallium nitride (GaN)-based LED or LD having a high emission efficiency, which is attracting attention as a semiconductor blue light-emitting element, and a phosphor as a wavelength converting material, has been proposed as a source of luminescence for an image display device or a lighting system. For example, Patent Document 1 discloses a white light-emitting device composed of a blue LED or LD chip made of a nitride-based semiconductor and a cerium-activated yttrium-aluminum-garnet phosphor whose Y has been partially substituted with Lu, Sc, Gd or La, in which blue light and yellow light emitted from the phosphor are mixed to obtain white light. Patent Document 2 discloses, for example, a color-converting molded member, a LED lamp, and other devices obtained by combining yttrium-aluminum oxide fluorescent materials activated with cerium having at least one element component selected from the group consisting of Ba, Sr, Mg, Ca and Zn, and/or a Si element component.

Further, Patent Document 3 discloses a cerium-activated yttrium-aluminum-garnet phosphor whose Y has been partially substituted with Sm. Patent Document 4 and Patent Document 5 disclose the effects of a Tb-added cerium-activated yttrium-aluminum-garnet phosphor.

However, known cerium-activated yttrium-aluminum-garnet phosphors do not have a satisfactory brightness, and their emission properties are still insufficient.

On the other hand, it is generally well known that the emission wavelength of a semiconductor light-emitting element such as a LED or LD is unstable because it varies according to environmental conditions such as temperature, humidity, and the amount of energization. In particular, a semiconductor light-emitting element is highly dependent on temperature, thus the emission wavelength thereof is varied by the environmental temperature or heat generated particularly by energization. It is also known that the wavelength varies between production lots, or due to the deterioration of the semiconductor light-emitting element itself. However, using existing techniques, it is difficult to suppress changes in the emission wavelength of a semiconductor light-emitting element, and make the semiconductor light-emitting element emit light having a constant wavelength.

Accordingly, there are problems that the above-described known cerium-activated yttrium-aluminum-garnet phosphors provide an insufficient emission intensity when they are used in combination with a semiconductor light-emitting element to make a white light-emitting device, and that the emission wavelength of the light-emitting device is unstable because of the unstable emission wavelength of the semiconductor light-emitting element.

Patent Document 1: Japanese Patent Application Laid-Open (JP-A) No. 10-190066
Patent Document 2: Japanese Patent Application Laid-Open (JP-A) No. 10-247750
Patent Document 3: Japanese Patent Application Laid-Open (JP-A) No. 10-242513
Patent Document 4: Japanese Patent Application National Publication (Laid-Open) No. 2003-505582
Patent Document 5: Japanese Patent Application National Publication (Laid-Open) No. 2003-505583

As described above, it is difficult to control the emission wavelength of a semiconductor light-emitting element. Therefore, in order to produce a light-emitting device which stably emits light, a phosphor having a broad excitation band, or a broad excitation spectrum is needed. Further, in order to produce a light-emitting device having a desired luminescent color, a technique for adjusting the wavelength of emission peak of a phosphor is also needed.

However, known cerium-activated yttrium-aluminum-garnet phosphors such as those described in Patent Documents 1 to 5 are unsatisfactory in terms of the stability of light emission and brightness. Therefore, there is a need for a high-performance yellow phosphor which satisfies the above-described requirements.

Disclosure of Invention

The present invention has been made in view of the above problems. An object of the present invention is to provide a cerium-activated yttrium-aluminum-garnet phosphor which emits yellow light, the phosphor exhibiting excellent stability of light emission and a high brightness, a method of stably producing the phosphor, a phosphor-containing composition and a light-emitting device including the phosphor, and an image display device and a lighting system including the light-emitting device.

The phosphor according to a first aspect contains a crystal phase of the chemical composition expressed by the following general formula [1], the phosphor exhibiting an average variation rate of the emission intensity of 1.3 or less upon excitation with light having a peak in the wavelength range of 420 nm to 480 nm, the variation rate of the emission intensity being calculated by the following general formula [2].

$$(Ln_{1-a-b}Ce_aTb_b)_3M_5O_{12} \qquad [1]$$

wherein Ln is at least one element selected from the group consisting of Y, Gd, Sc, Lu, and La, M represents at least one element selected from the group consisting of Al, Ga, and In, and a and b satisfy $0.001 \leq a \leq 0.3$ and $0 \leq b \leq 0.5$, respectively.

$$\text{Variation rate of emission intensity} = [\,(I(\lambda + 1) - I(\lambda))/I(\lambda)]^2 \quad [2]$$

wherein $I(\lambda)$ is the emission intensity of the phosphor at an excitation wavelength of $\lambda$ nm, and $I(\lambda + 1)$ is the emission intensity of the phosphor at an excitation wavelength of $(\lambda + 1)$ nm.

The phosphor according to a second aspect has an object color which satisfies $L^* \geq 90$, $a^* \leq -7$, and $b^* \geq 55$ under a color system of $L^*$, $a^*$, and $b^*$, contains a crystal phase having a chemical composition expressed by the following general formula [1], and has a median diameter $D_{50}$ of 15 $\mu$m or more:

$$(Ln_{1-a-b}Ce_aTb_b)_3M_5O_{12} \qquad [1]$$

wherein Ln is at least one element selected from the group consisting of Y, Gd, Sc, Lu, and La, M represents at least one element selected from the group consisting of Al, Ga, and In, and a and b satisfy $0.001 \leq a \leq 0.3$ and $0 \leq b \leq 0.5$, respectively.

The method of producing a phosphor according to a third aspect is a method of producing the phosphor of the first aspect, comprising mixing raw materials containing constituent elements, and then firing the mixture, wherein the molar ratio between the charged raw materials satisfies $(5/3) < (M/(Ln_{1-a-b}Ce_aTb_b)$, and the fired product obtained by firing is subjected to washing with acid.

The method of producing a phosphor according to a fourth aspect is a method of producing the phosphor of the second aspect, comprising raw materials containing constituent elements, and then firing the mixture, wherein the molar ratio between the charged raw materials satisfies $(5/3) < (M/(Ln_{1-a-b}Ce_aTb_b)$, and the fired product obtained by firing is subjected to washing with acid.

The phosphor-containing composition according to a fifth aspect includes the phosphor according to the first aspect and a liquid medium.

The light-emitting device according to a sixth aspect has a first light emitter which emits light ranging from the ultraviolet to visible region, and a second light emitter which converts the wavelength of at least a portion of light emitted from the first light emitter to emit light in a longer wavelength range than that of the light emitted by the first light emitter, wherein the second light emitter includes the phosphor according to the first aspect.

The image display device according to a seventh aspect uses the light-emitting device according to the sixth aspect as a light source.

The lighting system according to an eighth aspect uses the light-emitting device according to the sixth aspect as a light source.

Brief Description of the Drawings

Fig. 1 is a schematic cross-sectional view of an embodiment of the light-emitting device of the present invention.

Fig. 2 is a schematic cross-sectional view of an example of a surface emitting lighting system including the light-emitting device of the present invention.

Fig. 3 is a schematic perspective view of another embodiment of the light-emitting device of the present invention.

Fig. 4 is an emission spectrum of the light-emitting device made in Example 1.

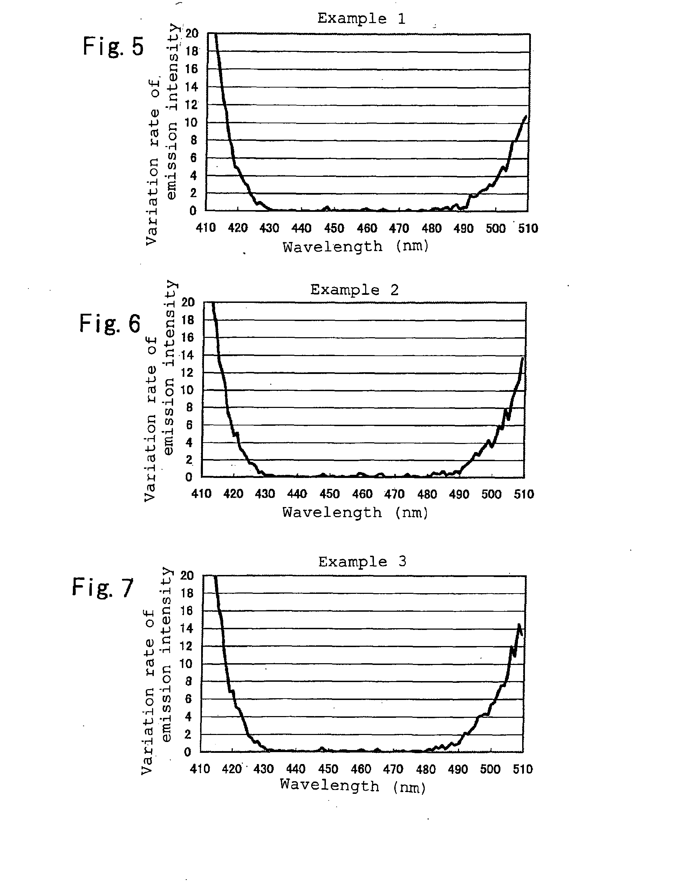

Fig. 5 is a graph showing the variation rate of the emission intensity of the phosphor of Example 1.

Fig. 6 is a graph showing the variation rate of the emission intensity of the phosphor of Example 2.

Fig. 7 is a graph showing the variation rate of the emission intensity of the phosphor of Example 3.

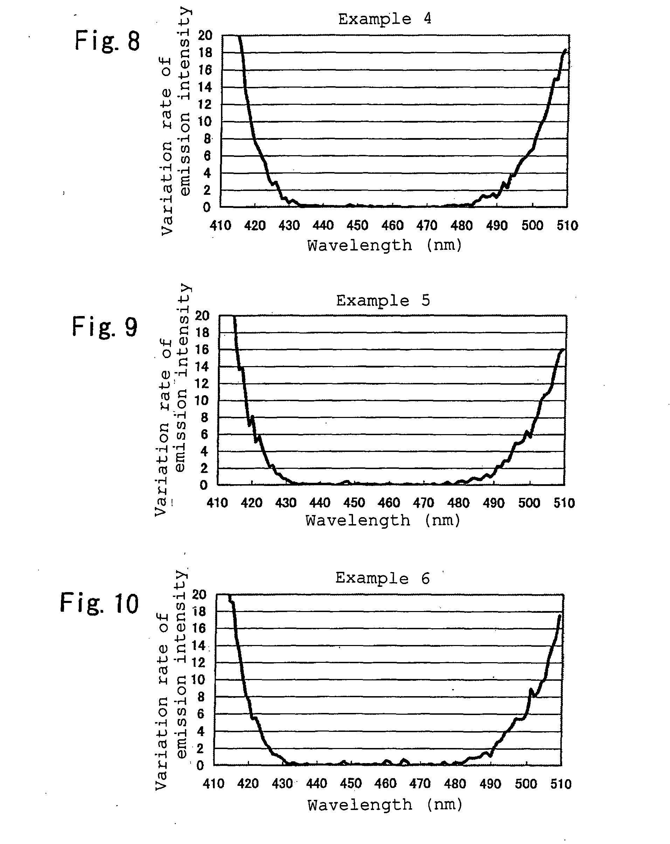

Fig. 8 is a graph showing the variation rate of the emission intensity of the phosphor of Example 4.

Fig. 9 is a graph showing the variation rate of the emission intensity of the phosphor of Example 5.

Fig. 10 is a graph showing the variation rate of the emission intensity of the phosphor of Example 6.

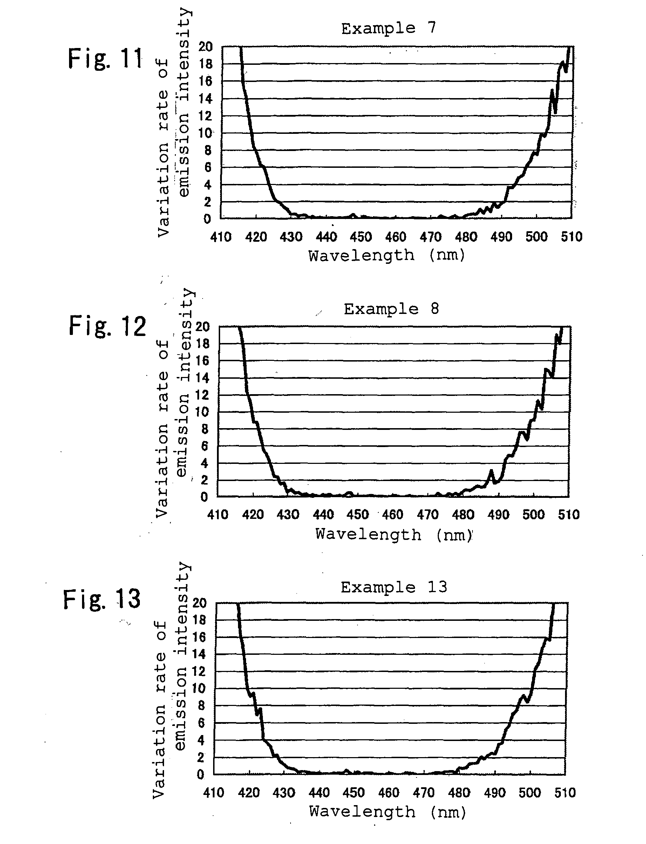

Fig. 11 is a graph showing the variation rate of the emission intensity of the phosphor of Example 7.

Fig. 12 is a graph showing the variation rate of the emission intensity of the phosphor of Example 8.

Fig. 13 is a graph showing the variation rate of the emission intensity of the phosphor of Example 13.

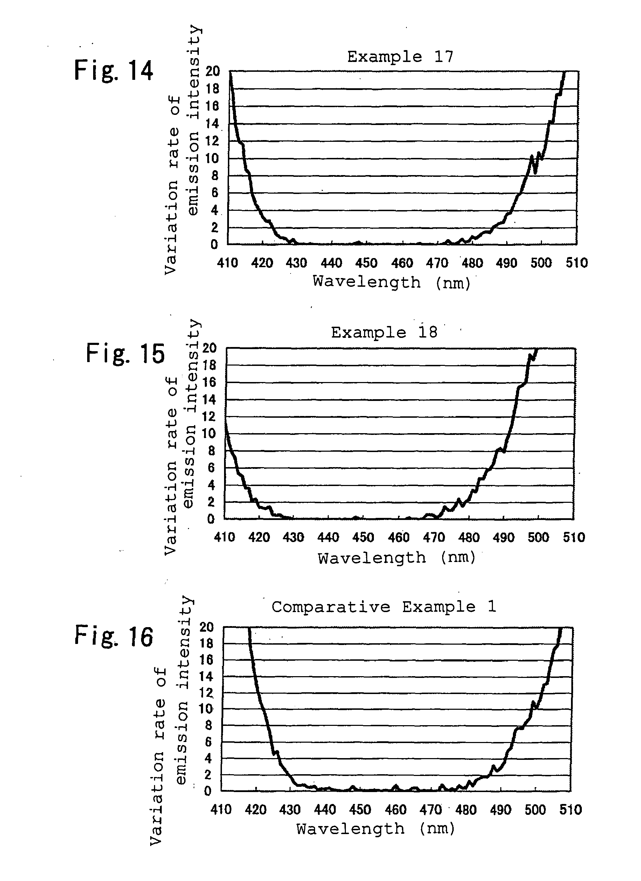

Fig. 14 is a graph showing the variation rate of the emission intensity of the phosphor of Example 17.

Fig. 15 is a graph showing the variation rate of the emission intensity of the phosphor of Example 18.

Fig. 16 is a graph showing the variation rate of the emission intensity of the phosphor of Comparative Example 1.

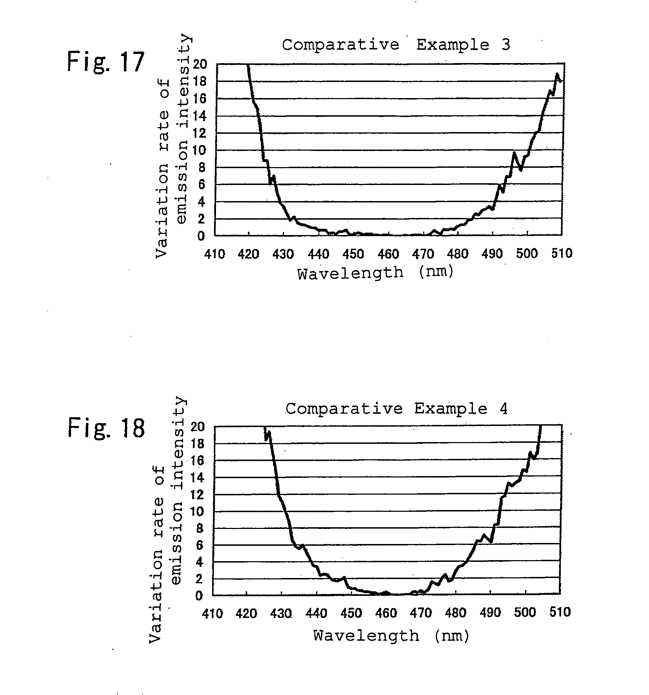

Fig. 17 is a graph showing the variation rate of the emission intensity of the phosphor of Comparative Example 3.

Fig. 18 is a graph showing the variation rate of the emission intensity of the phosphor of Comparative Example 4.

Fig. 19 is a graph showing the excitation spectrum in Example 1 and Comparative Example 4.

Detailed Description of the Invention

As a result of detailed study on the composition ratios and production methods of phosphors in view of the above problems, the inventors have found that a phosphor which has a specific composition range and exhibits a smaller average variation rate of the emission intensity upon excitation with a wavelength in the range of 420 nm to 480 nm provides excellent stability of light emission and has a high brightness as an yellow phosphor. They also have found that the phosphor is produced with the addition of Al, Ga and/or In element sources in an amount greater than the theoretical value calculated for the stoichiometric composition, and washing the phosphor with an acid. Further, the inventors minutely studied other properties of phosphors, and found that a phosphor having an object color, a particle size, and a circularity within a specific range provides a particularly high brightness. Further, the inventors found that the phosphor exhibits remarkably excellent properties as an yellow light source, and is suitable for applications such as a light-emitting device, and they thus accomplished the present invention.

According to the present invention, a phosphor which emits yellow fluorescence, exhibits excellent stability of light emission, and has a high brightness is provided, and the phosphor can be industrially produced with stability. Further, a highly efficient light-emitting device which stably emits light is obtained through the use of a composition containing the phosphor. The light-emitting device is suitable for applications such as an image display device or a lighting system.

The embodiment of the present invention is described below, but the configuration described below is an example (typical example) of embodiments of the present invention, and the present invention is not particularly limited to these descriptions without departing from the scope thereof.

In the present description, the range of values represented using "to" refers to the range covering the values around "to" as the lower and upper limits. Further, any of the relationship between a color name and a color coordinate in the present description is based on Japanese Industrial Standard (JIS Z8110).

[Phosphor] The phosphor of the present invention contains a crystal phase having a chemical composition expressed by the following general formula [1], and exhibits an average variation rate of the emission intensity of 1.3 or less upon excitation with light having a peak in the wavelength range of 420 nm to 480 nm, the variation rate of the emission intensity being calculated by the following general formula [2]. More specifically, the variation rate of the emission intensity at an excitation wavelength, which is changed from 420 nm to 480 nm at intervals of 1 nm, is calculated by the following general formula [2], and the average of the calculated values is 1.3 or less.

$$(Ln_{1-a-b}Ce_aTb_b)_3M_5O_{12} \qquad [1]$$

wherein Ln is at least one element selected from the group consisting of Y, Gd, Sc, Lu, and La, M represents at least one element selected from the group consisting of Al, Ga, and In, and a and b satisfy $0.001 \leq a \leq 0.3$ and $0 \leq b \leq 0.5$, respectively.

$$\text{Variation rate of emission intensity} = [(I(\lambda + 1) - I(\lambda))/I(\lambda)]^2 \quad [2]$$

wherein $I(\lambda)$ is the emission intensity of the phosphor at an excitation wavelength of $\lambda$ nm, and $I(\lambda + 1)$ is the emission intensity of the phosphor at an excitation wavelength of $(\lambda+1)$ nm.

[Chemical composition]

In the general formula [1], Ln is at least one element selected from the group consisting of Y, Gd, Sc, Lu, and La. Ln may contain any one of these elements, or two or more of them in an optional combination and/or at an optional ratio. It is particularly preferable that Ln contain at least Y, and Y be a main constituent element.

Lu as Ln in the general formula [1] particularly preferably coexists with Y. When Y and Lu coexist, the dominant emission wavelength is shifted to the shorter wavelength side, which results in a higher brightness. In this case, the lower limit of the Lu content is usually 0.03 or more, preferably 0.05 or more, and more preferably 0.06 or more. The upper limit of the Lu content is usually 1 or less, preferably 0.6 or less, and more preferably 0.15 or less. If the Lu content is greater than 1, the particle growth tends to be inhibited, which results in the decrease in the median diameter and brightness.

The Lu content corresponds to q when the general formula [1] is expressed by the following general formula [1A] :

$$Y_pLu_qCe_{3a}Tb_{3b}M_5O_{12} \qquad [1A]$$

wherein in the general formula [1A], M, a, and b are the same as those in the general formula [1], p and q represent the Y content and Lu content, respectively, and $Y_pLu_q = Ln_{3-3a-3b}$.

Ln in the general formula [1] may contain Gd or La, in addition to Y, to provide a longer dominant emission wavelength, which is suitable for a warm white LED.

M is at least one element selected from the group consisting of Al, Ga, and In. M may contain any one of these elements, or two or more of them in an optional combination and/or at an optional ratio. In particular, M preferably contains at least Al.

M may contain Ga in addition to Al to shift the dominant emission wavelength to the short wavelength side. In this case, the lower limit of the Ga content is usually 0.2 or more, and preferably 0.5 or more. The upper limit of the Ga content is usually 3 or less, preferably 2.5 or less, and more preferably 2 or less. If the Ga content is greater than 3, the emission peak wavelength tends to be excessively shifted to the short wavelength side, which results in the decrease of the emission efficiency.

The Ga content corresponds to r when the general formula [1] is expressed by the following general formula [1B] :

$$(Ln_{1-a-b}Ce_aTb_b)_3M'_{5-r}Ga_rO_{12} \qquad [1B]$$

In the general formula [1B], Ln, a, and b are the same as those in the general formula [1], M' represents M other than Ga (M is the same as that in the general formula [1]), and $M'_{5-r}Ga_r = M_5$.

"a" representing the molar ratio of Ce satisfies $0.001 \leq a \leq 0.3$, wherein the lower limit thereof is preferably a $\geq 0.01$, more preferably a > 0.01, and further preferably a $\geq 0.02$ from the viewpoint of achieving a higher emission intensity, and the upper limit thereof is preferably a $\leq 0.2$, more preferably a $\leq 0.18$, and further preferably a $\leq 0.15$.

As described above, the phosphor can be adjusted in the emission wavelength or brightness thereof according to the composition thereof. Accordingly, in cases where the phosphor of the present invention is combined with a semiconductor light-emitting element to make a light-emitting device, a desired luminescent color can be obtained by adjusting the luminescent color or emission intensity by changing the composition of the phosphor of the present invention.

[Properties of excitation spectrum]

The phosphor of the present invention has the following properties when measured for the excitation spectrum thereof. The dominant peak wavelength $\lambda_p$ (nm) of the excitation spectrum of the phosphor of the present invention is usually 420 nm or more, particularly preferably 430 nm or more, in addition, usually 500 nm or less, and particularly preferably 490 nm or less from the viewpoint of the relationship with the emission wavelength of the below-described first light emitter.

The full width at half maximum (hereinafter appropriately abbreviated as "FWHM") of the phosphor of the present invention in the above-described excitation spectrum is usually wider than 93 nm, and particularly preferably 95 nm or more. If the FWHM is too narrow, light emission is unstable, which may result in the undesirable decrease of the emission intensity.

Further, the shape of the excitation spectrum phosphor of the present invention is preferably flat, or has a broad peak at the wavelengths (420 nm to 480 nm) around the wavelength of emission peak of the below-described first light emitter to be combined with the phosphor of the present invention. The flatness of the excitation spectrum at the wavelengths around the wavelength of emission peak of the first light emitter is preferably higher for decreasing the below-described average variation rate of the emission intensity to stabilize light emission.

[Average variation rate of emission intensity]

The phosphor of the present invention exhibits an average variation rate of the emission intensity of 1.3 or less, preferably 1.1 or less, and more preferably 1.0 or less over the excitation wavelength range of 420 nm to 480 nm, the variation rate of the emission intensity being calculated by the following general formula [2].

$$\text{Variation rate of emission intensity} = [(I(\lambda + 1) - I(\lambda))/I(\lambda)]^2 \quad [2]$$

wherein $I(\lambda)$ is the emission intensity of the phosphor at an excitation wavelength of $\lambda$ nm, and $I(\lambda + 1)$ is the emission intensity of the phosphor at an excitation wavelength of $(\lambda + 1)$ nm.

The phosphor of the present invention thus exhibits a small variation rate of the emission intensity over a wide wavelength range thereby expanding the appropriate allowable width of the excitation light (the emission wavelength of the first light emitter in the light-emitting device of the present invention).

If the average variation rate of the emission intensity exceeds 1.3, the emission wavelength of the first light emitter such as a semiconductor light-emitting element varies, which results in the significant change of the luminescent color of the phosphor as the second light emitter. The lower limit of the average variation rate of the emission intensity is preferably nearer to 0 to stabilize light emission.

The average variation rate of the emission intensity may be determined by the method described in the below-described section of EXAMPLES. The FWHM of the excitation spectrum is preferably wider to decrease the average variation rate of the emission intensity. As described above, the FWHM is, specifically, preferably 93 or more, and particularly preferably 95 or more.

[Weight average median diameter $D_{50}$]

The inventors studied the particle size of the phosphor as follows.

Phosphors generally have many structural defects on the surface thereof and thus have a low emission efficiency. Accordingly, the larger the particle size of the phosphor, the lower proportion of the low-luminous portion on the surface to the whole particle, which results in a higher emission efficiency. However, heretofore, phosphors having a median diameter $D_{50}$ of 1 $\mu$m to 10 $\mu$m have been generally and frequently used.

Display devices are often required to have a high resolution. In order to reproduce a high definition image, the size of one pixel must be small. On the other hand, in order to efficiently collide excitation light incident on a phosphor layer against the phosphor without passing through as it is, the phosphor layer must have about three layers of the phosphor particles. Taking a direct-view cathode ray tube (CRT) for example, each application width of blue, green, and red phosphor stripes is 30 $\mu$m in that having a highest definition, or 100 $\mu$m in that having an average definition. Therefore, the phosphor size is 7 $\mu$m to 8 $\mu$m at a maximum. A projection CRT does not require the formation of fine pixels because one color phosphor is applied to one tube. However, light diffusion caused by scattering during passing through the phosphor layer is proportional to the film thickness. Accordingly, the thickness of the phosphor layer must be minimized to obtain a high resolution image. Therefore, phosphors having a particle size of about 10 $\mu$m at a maximum are frequently used.

On the other hand, lighting devices offer no problem in resolution. However, for example, as is seen with a fluorescence lamp, a phosphor having a too large particle size sediments too fast, which makes it difficult to stably make a phosphor layer on the lamp tube wall. Therefore the appropriate range of the particle size is from 1 $\mu$m to 4 $\mu$m.

Further, regarding the production method, although it is possible in principle to averagely increase the particle size by firing at a high temperature for a long time, the particle size can be increased by local abnormal particle growth, fusion between phosphor particles, or other reasons, which inevitably produces a phosphor having an extremely wide particle size distribution. Accordingly, extensive screening is indispensable for obtaining a required particle size distribution, which extremely deteriorates the production yield.

For that reason, phosphors having a small particle size have been used in prior art. However, the phosphor of the present invention preferably has a larger particle size to achieve a higher brightness.

In the present description, the weight-average median diameter $D_{50}$ is a value determined from a particle size distribution curve. The particle size distribution curve is obtained by measuring the particle size distribution by a laser diffraction scattering method. Specifically, a phosphor is dispersed in an aqueous solution containing a dispersant, and particles in a range of 0.1 $\mu$m to 600 $\mu$m are measured with a laser diffraction particle size distribution analyzer (manufactured by Horiba, Ltd. LA-300). In the particle size distribution curve, the particle size at the integrated value of 50% is defined as a weight-average median diameter $D_{50}$ (hereinafter referred to as "median diameter $D_{50}$"). The particle sizes at the integrated values of 25% and 75% are indicated with $D_{25}$ and $D_{75}$, respectively. The standard deviation (quantile deviation) is defined as QD = $(D_{75}-D_{25}) / (D_{75}+D_{25})$. A small QD means a narrow particle size distribution.

The phosphor of the present invention usually has a generally normal particle size distribution, and the lower limit of the median diameter $D_{50}$ is 10 $\mu$m or more, preferably 14 $\mu$m or more, particularly preferably 15 $\mu$m or more, and further preferably 17 $\mu$m or more. On the other hand, the upper limit of the median diameter $D_{50}$ is preferably 40 $\mu$m or less, further preferably 30 $\mu$m or less, and particularly preferably 25 $\mu$m or less.

If the median diameter $D_{50}$ is less than 10 $\mu$m, the absorbance for blue excitation light is low, which results in the failure to obtain a phosphor having a high brightness. On the other hand, if the median diameter $D_{50}$ is more than 40 $\mu$m, a practical inconvenience may occur in a nozzle device or the like.

The particle size distribution QD of the phosphor of the present invention is usually 0.5 or less, preferably 0.3 or less, and particularly preferably 0.25 or less.
In cases where a plurality of phosphors having different median diameters $D_{50}$ are used as a mixture in order to increase the emission efficiency and light absorbance, the mixed phosphor may have a QD greater than 0.3.

[Shape]

The inventors studied various particle shapes of the phosphor to be used in the light-emitting device of the present invention, and found that a more efficient light-emitting device is produced through the use of a phosphor having a higher sphericity. Therefore, an average circularity was used as the index for quantitatively representing the sphericity of a phosphor particle. The average circularity refers to the circularity representing the degree of approximation to a perfect circle of the particle size on a projection of a particle (circularity = perimeter of a perfect circle having the same area as the projected area of the particle/perimeter of a projection of the particle). A perfect sphere has an average circularity of 1.

If the average circularity of a phosphor is less than 0.86, the emission efficiency of a light-emitting device including the same may be insufficient. Accordingly, the average circularity of the phosphor of the present invention is preferably 0.86 or more, particularly preferably 0.88 or more, and most preferably from 0.9 to 1.

Further, if the phosphor has an odd shape such as a needle shape, a plate shape, or a cluster in which particles are fused together, it tends to cause undesirable aggregation in a dispersion medium to hinder the formation of a uniform phosphor layer. Further, in cases where the phosphor emits light whose wavelength has been converted by the phosphor, any anisotropy in the shape may bias the emission distribution.

[Object color]

The inventors studied the improvement of the emission efficiency of cerium-activated yttrium-aluminum-garnet phosphors, and found that the object color thereof significantly can differ among phosphors having the exactly same composition and same crystal system. They also found that the object color of the phosphor of the present invention is strongly correlated with the luminance of the phosphor when mounted on a light-emitting device, and that the efficiency of the light-emitting device tends to increase through the use of a phosphor having a higher b* value than that of prior art phosphors, wherein the L* and a* values are at the same level between them.

The phosphor of the present invention preferably has L*, a*, and b* values which satisfy the following formula, when the object color thereof is expressed under a color system of L*, a*, and b*.

$$L* \geq 90$$

$$a* \leq -7$$

$$b* \geq 55$$

When the phosphor of the present invention has an object color which satisfies the above-described conditions, the below-described light-emitting device including the phosphor achieves a high emission efficiency.

Specifically, the upper limit of the L* value will not usually exceed 100 because an object which does not emit light by irradiation light is used, but the phosphor of the present invention is excited with an irradiation light source to emit light which is superimposed to reflected light, so that the L* value may exceeds 100. Accordingly, the upper limit of the L* value is usually $L* \leq 115$, and the lower limit of the L* value is usually $L* \geq 90$. If the L* value is lower than the above-described range, light emission weakens.

The upper limit of the a* value is usually $a* \leq -7$, and preferably $a* \leq -10$. On the other hand, the lower limit of the a* value is usually $a* \geq -30$, and preferably $a* \geq -25$. If the a* value is too large, the entire luminous flux tends to diminish. Therefore, the a* value is preferably smaller.

The b* value is usually $b* \geq 55$, preferably $b* \geq 80$, more preferably $b* \geq 85$, and further preferably $b* \geq 90$. Since that having a small b* value is unsuitable for improving the emission efficiency of a light-emitting device, the phosphor of the present invention preferably has a high b* value. The upper limit of the b* value is theoretically $b* \leq 200$, and usually $b* \leq 120$.

[ Absorbance $\alpha$]

The phosphor of the present invention preferably has an absorbance $\alpha$ of 0.6 or more, and particularly 0.65 or more for photons, which is determined by the below-described method. The upper limit of the $\alpha$ value is substantially 1. When the phosphor satisfies the conditions, in the below-described light-emitting device of the present invention, the number of photons which are elementary excitable within the phosphor as the second light emitter increases among the photons emitted from the first light emitter, which results in the increase of the number of photons released from the phosphor per unit time. More specifically, a light-emitting device having a high emission intensity is obtained. The term "elementary excitation" means energy excitation owing to a change of the spin state of Ce (usually referred to as "emission center excitation"), energy excitation owing to a change in the average number of electrons having an existence probability in the vicinity of each ion (usually referred to as "CT excitation"), energy excitation owing to a band-to-band transition of electrons (usually called "band excitation"), or the like.

The method for determining the absorbance $\alpha$ is described below.

In the first place, a phosphor sample to be measured in powder or other form is charged into a cell with the surface of the sample thoroughly flattened to keep the accuracy of measurement, and the cell is mounted on a spectrophotometer equipped with an integrating sphere and others. Examples of the spectrophotometer include "MCPD2000" manufactured by Otsuka Electronics Co., Ltd. The integrating sphere is used here in order to count all the photons reflected by the sample and photons released from the sample by photoluminescence, more specifically, in order to prevent photons from scattering out of the measurement system and slipping out from the measurement data. A light source for exciting the phosphor is attached to the spectrophotometer. The light source is, for example, a Xe lamp, the emission peak wavelength of which is adjusted to 465 nm using a filter or the like. The sample to be measured is exposed to light from the light source having a wavelength peak adjusted at 465 nm, and the emission spectrum of the sample is measured. The spectrum thus measured includes, in addition to the photons released from the sample by photoluminescence using the light from an excitation light source (hereinafter simply referred to as "excitation light"), photons of the excitation light reflected by the sample.

The absorbance $\alpha$ is a quotient obtained by dividing the number of photons Nabs of the excitation light absorbed by the sample by the total number of photons N of the excitation light. The latter total number N of photons of the excitation light is determined as follows. In the first place, a substance having a reflectance R of substantially 100% to the excitation light, for example, "Spectralon" (having a reflectance of 98% to the excitation light of 465 nm) manufactured by Labsphere, Inc. is attached to the spectrophotometer as an object to be measured, and its reflection spectrum $I_{ref}(\lambda)$ is measured. The value determined from this reflection spectrum $I_{ref}(\lambda)$ in accordance with the following [3] is proportional N.

$$\int \lambda \cdot I_{ref}(\lambda) \, d\lambda \qquad [3]$$

In the above formula, the integral interval may be an interval in which $I_{ref}(\lambda)$ has a substantially significant value. The former Nabs is in proportion to the amount determined in accordance with the following [4].

$$\int \lambda \cdot I(\lambda) \, d\lambda \, - \, \int \lambda \cdot I_{ref}(\lambda) \, d\lambda \qquad [4]$$

In the above formula, I($\lambda$) is an emission spectrum of the sample to be measured for its $\alpha$ is attached. The integral range of [4] is made equal to that defined for [3]. By thus defining the integral range, the first term of [4]($\int \lambda \cdot I(\lambda)$ d$\lambda$) corresponds to the number of photons generated by the reflection of excitation light by the sample, more specifically, the number of photons obtained by subtracting photons generated through photoluminescence by the excitation light from the total number of photons generated from the sample. The actual spectral data is obtained as digital data divided by some finite bandwidths relating to $\lambda$ so that the integral of [3] and [4] is determined by a finite sum based on the bandwidths. This leads to the following formula:

$$\alpha \, = \, N_{abs}/N \, = \, [3]/[4]$$

An increase in the absorbance $\alpha$ itself is expected to heighten the brightness because it usually leads to a rise in the number of photons from the excitation light source introduced into a sample. In practice, however, an attempt to increase the $\alpha$ value by increasing the concentration of Ce or the like serving as an luminescent center did not lead to sufficient emission intensity, because prior to the arrival of photons to the final photoluminescence step, a probability to change the energy to phonon excitation in the sample crystal increased. It has been found, however, that when the wavelength of the excitation light source is particularly in the range of 420 nm to 500 nm, and a phosphor having a high absorbance $\alpha$ is used as the second light emitter of the light-emitting device, the above-described non-photoluminescence step is suppressed, and a light-emitting device with a high emission intensity can be actualized.

[Phosphor production method]

The production method of the phosphor of the present invention is described below. The phosphor of the present invention can be made by mixing the raw material of the metal element Ln (hereinafter appropriately referred to as "Ln source"), the raw material of Ce (hereinafter appropriately referred to as "Ce source"), the raw material of Tb (hereinafter appropriately referred to as "Tb source"), and the raw material of the metal element M (hereinafter appropriately referred to as "M source"), which have been referred in the above-described general formula [1], (mixing step), and then firing the obtained mixture (firing step).

The phosphor of the present invention cannot be made by the prior art production method. The phosphor production method of the present invention includes, in the mixing step thereof, adding the M source in an amount greater than the stoichiometric composition, that is, such that the charge molar ratio satisfies $(5/3) < (M/(Ln_{1-a-b}Ce_aTb_b)$ (when two or more kinds of M elements are used, the total number of moles). The M source is preferably $\alpha$-alumina. Through the use of an excess amount of M as described above, a phosphor which stably emits light and satisfies the composition of the general formula [1] and the average variation rate of the emission intensity according to the formula [2] is industrially and stably produced. Further, the phosphor production method of the present invention tends to accelerate the crystal growth to increase the particle size.

The method for industrially and stably produce a cerium-activated yttrium-aluminum-garnet phosphor having a large particle size is not described in Patent Document 4 or Patent Document 5, and is unknown.

Raw material

Examples of the Ln source, Ce source, Tb source, and M source to be used for the production of the phosphor of the present invention include oxides, hydroxides, carbonates, nitrates, sulfates, oxalates, carboxylates, and halides of each element. The sources are selected from above salts in consideration of reactivity to a complex oxide, low level of production of halogens, $NO_x$, $SO_x$ and others during firing, and other factors.

Specific examples of the Ln source are listed below, classified according to the kind of the Ln element.

Specific examples of the Y source include $Y_2O_3$, $Y(OH)_3$, $YCl_3$, $YBr_3$, $Y_2(CO_3)_3 \cdot 3H_2O$, $Y(NO_3)_3 \cdot 6H_2O$, $Y_2(SO_4)_3$, and $Y_2(C_2O_4)_3 \cdot 9H_2O$.

Specific examples of the Gd source include $Gd_2O_3$, $Gd(OH)_3$, $GdCl_3$, $Gd(NO_3)_3 \cdot 5H_2O$, and $Gd2(C_2O_4)_3 \cdot 10H_2O$.

Specific examples of the La source include, $La_2O_3$, $La(OH)_3$, $LaCl_3$, $LaBr_3$, $La_2(CO_3)_3 \cdot H_2O$, $La(NO_3)_3 \cdot 6H_2O$, $La_2(SO_4)_3$, and $La_2(C_2O_4)_3 \cdot 9H_2O$.

Specific examples of the Sc source include $Sc_2O_3$, $Sc(OH)_3$, $ScCl_3$, $Sc(NO_3)_3 \cdot nH_2O$, $Sc_2(SO_Q)_3 \cdot nH_2O$, and $Sc_2(C_2O_4)_3 \cdot nH_2O$.

Specific examples of the Lu source include $Lu_2O_3$, $LuCl_3$, $Lu(NO_3)_3 \cdot 8H_2O$, and $Lu_2(OCO)_3 \cdot 6H_2O$.

Specific examples of the M source is listed below, classified according to the kind of the M element.

Specific examples of the Al source include $Al_2O_3$ such as $\alpha$-$Al_2O_3$ and $\gamma$-$Al_2O_3$, $Al(OH)_3$, $AlOOH$, $Al(NO_3)_3 \cdot 9H_2O$, $Al_2(SO_4)_3$, and $AlCl_3$. Among them, $\alpha$-$Al_2O_3$ is particularly preferable.

Specific examples of the Ga source include $Ga_2O_3$, $Ga(OH)_3$, $Ga(NO_3)_3 \cdot nH_2O$, $Ga_2(SO_4)_3$, and $GaCl_3$.

Specific examples of the In source include $In_2O_3$, $In(OH)_3$, $In(NO_3)_3 \cdot nH_2O$, $In_2(SO_4)_3$, and $InCl_3$.

Specific examples of the Ce source include $CeO_2$, $Ce_2(SO_4)_3$, $Ce_2(CO_3)_3 \cdot 5H_2O$, $Ce(NO_3)_3 \cdot 6H_2O$, $Ce_2(C_2O_4)_3 \cdot 9H_2O$, $Ce(OH)_3$, and $CeCl_3$.

Specific examples of the Tb source include $Tb_4O_7$, $Tb_2(SO_4)_3$, $Tb(NO_3)_3 \cdot nH_2O$, $Tb_2(C_2O_4)_3 \cdot 10H_2O$, and $TbCl_3$.

The raw material compounds may be used alone or in combination of two or more of them.

M source

The phosphor production method of the present invention includes a step of mixing the above-described raw materials such that the charge molar ratio satisfies $(5/3) < (M/(Ln_{1-a-b}Ce_aTb_b))$ (when two or more kinds of M elements are used, the total number of moles), that is, the M element is in excess of the stoichiometric composition.

Further, the M source is preferably added in an amount greater than the requirement based on the stoichiometric composition by 1% to 10% (more specifically $5.05/3 \leq (M/(Ln_{1-a-b}Ce_aTb_b) \leq 5.5/3)$ . If the excess of the M source over the stoichiometric composition is less than 1%, the phosphor obtained tends to have a small particle size and exhibit instable light emission, which are not preferable. The upper limit of the excess of the M source over the stoichiometric composition is usually 10%. This is because the effect by the excessive addition is saturated.

Further, it is preferable to select A1 as the M element, and it is preferable to use $\alpha$-alumina as the A1 source. More specifically, when $\alpha$-alumina is used as the A1 source, the phosphor tends to have a desirable large particle size. In addition, a phosphor produced with the addition of $\alpha$-alumina as the Al source in an amount greater than the stoichiometric composition has an object color satisfying $L^* \geq 90$, $a^* \leq -7$, and $b^* \geq 55$ under a color system of $L^*$, $a^*$, and $b^*$. The object color can be optimized utilizing that the $b^*$ value increases in proportional to the addition amount of $\alpha$-alumina. Accordingly, it is particularly preferable to produce the phosphor using $\alpha$-alumina as the A1 source compound.

In a chemical analysis, the phosphor of the present invention exhibits a stoichiometric composition within precision of analysis even though it is produced with the addition of the M source in an amount greater than the stoichiometric composition as described above.

Ce source

It is absolute necessary to uniformly mix the raw materials to obtain a phosphor having a uniform composition. In particular, it is important to uniformly mix a rare earth raw material such as Ce which serves as the luminescent center ion. Accordingly, a rare earth raw material such as Ce has been preferably coprecipitated with other raw materials such as the Ln source before the below-described normal mixing step.

Examples of the method for coprecipitation include the following methods.

For example, other raw materials such as the Ln source and a rare earth raw material such as Ce are dissolved in a mineral acid such as hydrochloric acid or nitric acid to prepare a mixed rare earth solution. Subsequently, an oxalic acid solution or the like as a precipitant is slowly added to the mixed rare earth solution to prepare a complex rare earth oxalate precipitate. The precipitate is washed with pure water, followed by separation by filtration, and fired in the air at a temperature from 850°C to 1100°C, for example about 1000°C, thus a complex rare earth oxide is obtained. The thus obtained complex rare earth oxide is a raw material in which the other elements such as the Ln element and the rare earth element such as Ce are almost uniformly distributed in terms of the mixing ratio.

Mixing step

The technique for mixing the Ln source, Ce source, Tb source, and M source is not particularly limited, and examples thereof include the following dry processes and wet processes.

(1) Dry process: The above-described raw materials are pulverized using a dry mill such as a hammer mill, a roll mill, a ball mill, or a jet mill, and mixed using a mixer such as a ribbon blender, a V type blender, or a Henschel mixer. Alternatively, the above-described raw materials are mixed, and then pulverized using a dry mill.

(2) Wet process: The above-described raw materials are added to a medium such as water, and then pulverized and mixed using a wet mill such as a medium stirring mill. Alternatively, the above-described raw materials are pulverized using a dry mill, and then added to and mixed with a medium such as water, and thus prepared slurry is dried by spray drying or the like.

Among these pulverizing and mixing methods, a method using a liquid medium is preferable particularly for an element source compound for the luminescent center ion, which must be uniformly mixed all over and dispersed in a small amount. The wet method is preferable also for the other element source compounds, because it enables preparation of a uniform mixture of them.

Firing step

The firing step is usually conducted by placing the mixture of the raw materials such as the Ln source, Ce source, Tb source, and M source obtained by the above-described mixing step in a heat-resistant container such as a crucible or tray made of a material less reactive with the raw materials (for example, alumina or quartz), and heating it.
The temperature during firing is usually 1350°C or more, preferably 1400°C or more, and further preferably 1430°C or more, in addition, usually 1650°C or less, preferably 1630°C or less, and further preferably 1600°C or less. If the firing temperature is too low, the particle growth may be undesirably inhibited.
The pressure during firing varies according to the firing temperature etc., but is usually normal pressure or higher.
The firing time varies according to the temperature or pressure etc. during firing, but is usually in the range of 10 minutes to 24 hours.
The atmosphere during firing is not particularly limited, and specific examples thereof include any single atmosphere or mixed atmosphere of two or more selected from air, nitrogen, argon, carbon monoxide, hydrogen, and other gases. The optimum firing conditions vary according to the material, the composition ratio, and the batch size to be prepared etc., but a reducing atmosphere is usually preferable. In this case, the phosphor of the present invention cannot be obtained if the degree of reduction is too low or too high. Usually, a phosphor having an object color defined in the present invention tends to be produced through the use of a relatively strong reducing atmosphere, specifically such as a nitrogen-hydrogen mixed gas atmosphere containing 2 vol% to 4 vol% of hydrogen. Alternatively, a reducing atmosphere may be made using carbon (for example, carbon beads or graphite), but it tends to have so strong reducing power that it should be used as necessary.

Flux

In the firing step, the reaction system preferably contain a flux from the viewpoint of growing favorable crystals. The kind of the flux is not particularly limited, and examples thereof include chlorides such as $NH_4Cl$, $LiCl$, $NaCl$, $KCl$, $CsCl$, $CaCl_2$, $BaCl_2$, and $SrCl_2$, and fluorides such as $LiF$, $NaF$, $KF$, $CsF$, $CaF_2$, $BaF_2$, $SrF_2$, and $AlF_3$. Among them, $BaF_2$ and $AlF_3$ are preferable. The usage of the flux varies according to, for example, the kind of the raw materials and the material of the flux, but is usually 0.01% by weight or more, preferably 0.1% by weight or more, in addition, usually 20% by weight or less, and more preferably 10% by weight or less with reference to the total weight of the raw materials. If the usage of the flux is too small, the effect of the flux will not be exhibited, and if the usage of the flux excessive, the effect of the flux may be saturated, or the flux may be taken into the host crystals to change the luminescent color or decrease the brightness.

Aftertreatment

Following the above-described firing step, as necessary, washing, dispersion treatment, drying, classification, and others are conducted. Particularly in the present invention, the fired product obtained by firing is subjected to washing with acid. Further, in cases where the phosphor thus obtained is dispersed in a dispersion medium as described below, it may be subjected to known surface treatment as necessary.
Washing with acid of the fired product is conducted as follows. In the first place, the fired product obtained by firing is lightly pulverized, dispersed in an acidic aqueous solution in particle form, and then washed with water. The acidic aqueous solution used herein is preferably an aqueous solution containing usually about a 0.5 mol/l to 4 mol/l of acid. Specific examples thereof include one or two or more of inorganic acids such as hydrochloric acid, sulfuric acid, and nitric acid. Among them, hydrochloric acid is preferable.
Through such washing with acid, unreacted matter, byproducts, and the flux are dissolved and removed by separation. If the concentration of the acid aqueous solution used for the washing with acid is higher than 4 mol/l, it may dissolve the surface of the phosphor, and if less than 0.5 mol/l, it exhibits poor washing effect, both of which is undesirable.

[Application of phosphor]

The phosphor of the present invention is excellent in terms of the stability of light emission and brightness, so that it is favorably used in a phosphor-containing composition, various light-emitting devices (below-described "light-emitting device of the present invention"), image display devices, and lighting system. When the phosphor of the present invention, which is an yellow phosphor, is combined with a semiconductor blue light-emitting element or the like as a first light emitter, a white light-emitting device having a high emission intensity is actualized.

[Phosphor-containing composition]

In cases where the phosphor of the present invention is used for applications such as a light-emitting device, the phosphor is preferably used in the form of a dispersion in a liquid medium. The dispersion of the phosphor of the present invention in a liquid medium is appropriately referred to as "composition containing the phosphor of the present invention".

The liquid medium usable in the composition containing the phosphor of the present invention may be optionally selected from those exhibiting liquid properties under desired use conditions and favorably dispersing the phosphor of the present invention without causing undesirable reactions. Examples of the liquid medium include addition reaction curable silicone resins, condensation reaction curable silicone resins, modified silicone resins, epoxy resins, polyvinyl-based resins, polyethylene-based resins, polypropylene-based resins, and polyester-based resins. These liquid medium may be used alone, or two or more of them in an optional combination and/or at an optional ratio.

The usage of the liquid medium may be appropriately adjusted according to the intended use or the like, but in general cases, the usage is usually 3% by weight or more, preferably 5% by weight or more, in addition, usually 30% by weight or less, and preferably 20% by weight or less in terms of the weight ratio of the liquid medium with reference to the phosphor of the present invention.

Further, the composition containing the phosphor of the present invention may contain, in addition to the phosphor of the present invention and the liquid medium, other optional components according to the intended use or the like. Examples of the other components include a diffusing agent, a thickening agent, a filler, and an optical buffer. Specific examples thereof include silica-based fine powder such as AEROSIL and alumina.

The above-described composition containing the phosphor of the present invention is favorably used for the production of a light-emitting device.

[Light emitting device]

In the next place, the light-emitting device of the present invention is described below.

The light-emitting device of the present invention is composed at least a first light emitter which emits light ranging from the ultraviolet to visible region, and a second light emitter which converts the wavelength of at least a portion of light emitted from the first light emitter to emit light having a longer wavelength than that of the light emitted by the first light emitter. The light-emitting device of the present invention contains the above-described phosphor of the present invention as the second light emitter.

First light emitter

The first light emitter in the light-emitting device of the present invention emits light to excite the below-described second light emitter. The emission wavelength of the first light emitter is not particularly limited as long as it overlaps with the absorption wavelength of the below-described second light emitter, which allows to use a light emitter having a wide emission wavelength range. Usually, a light emitter having an emission wavelength from the violet region to the blue region is used, and specifically, a light emitter having an emission wavelength of usually 420 nm or more, preferably 430 nm or more, in addition, usually 500 nm or less, and preferably 490 nm or less is used.

Further, in cases where the wavelength of emission peak of the second light emitter is shorter than about 555 nm, the wavelength of the first light emitter to be combined is usually 445 nm or more, preferably 450 nm or more, in addition, usually 460 nm or less, and preferably 455 nm or less.

The first light emitter is usually a semiconductor light-emitting element, and specifically may be a LED, LD, or the like.

Among them, the first light emitter is preferably a GaN-based LED or LD composed of a GaN-based compound semiconductor, because their emission output or external quantum efficiency is by far great compared with an SiC-based LED emitting light of this region so that very bright light emission is available at a considerably low electricity by using it in combination with the above-described phosphor. For example, when a current of 20 mA is applied, a GaN-based LED or LD has an emission intensity at least 100 times that of an SiC-based one. The GaN-based LED or LD preferably has an $Al_xGa_yN$ luminescent layer, GaN luminescent layer, or $In_xGa_yN$ luminescent layer. Among the Gan-based LEDs, that having an $In_xGa_yN$ luminescent layer is particularly preferable because it has a remarkably high emission intensity. Among the GaN-based LDs, that having a multiple quantum well structure with an $In_xGa_yN$ layer and a GaN layer is particularly preferable because it has a remarkably high emission intensity.

In the above description, X+Y is usually a value in the range of 0.8 to 1.2. As the GaN-based LED, that with a luminescent layer having Zn or Si doped therein or no dopant therein is preferable for controlling the light emission properties.

The GaN-based LED is basically composed of the above-described luminescent layer, a p layer, an n layer, an electrode and a substrate, and preferably has a hetero structure in which the luminescent layer has been sandwiched between the n type and p type $Al_X Ga_Y N$ layers, GaN layers or $In_x Ga_y N$ layers for achieving a high emission efficiency, and more preferably has a quantum well structure as the hetero structure for achieving a higher emission efficiency.

Second light emitter

The second light emitter in the light-emitting device of the present invention contains a wavelength converting material which emits visible light upon irradiation with light from the above-described first light emitter. The second light emitter contains the phosphor of the present invention (yellow phosphor), and may appropriately contain, as described below, phosphors having an optional composition or color according to the intended use.

As the second light emitter, examples of the phosphor which may be used in combination with the phosphor of the present invention are listed below. Specific examples of green phosphors include $Ca_3 Sc_2 Si_3 O_{12}:Ce^{3+}$, (Sr, Ca, Mg)$Ga_2 S_4$:Eu and ZnS:Cu, Al. Specific examples of red phosphors include (Ca, Sr)S:Eu, $CaAlSiN_3:Eu^{2+}$. Further, a white substance such as $BaSO_4$, MgO, or $CaHPO_4$ may be used as a reflecting agent or a diffusing agent in combination with the phosphor of the present invention.

Examples of the method for combining these phosphors include a method of stacking layers of the phosphors in powder form, a method of stacking layers of the mixtures of the phosphors and a resin, a method of mixing the phosphors in powder form, a method of dispersing the phosphors in a resin, and a method of stacking in the form of thin film crystals. Among them, the method of mixing, controlling, and using the phosphors in powder form is preferable for producing white light in the simplest manner and at the lowest cost.

The second light emitter may contain the phosphor of the present invention alone, or may further contain at least one cerium and/or terbium-activated yttrium-aluminum-garnet phosphor having a different composition. This enables to adjust the emission spectrum of the second light emitter according to the properties (emission wavelength) of the first light emitter to obtain a desired luminescent color.

As the method for adjusting the emission wavelength of the second light emitter, the present invention discloses the following three methods: (1) partially substituting aluminum with gallium; (2) partially substituting yttrium with lutetium; and (3) adjusting the amount of the activator in a yttrium-aluminum-garnet phosphor. Alternatively, a first phosphor and a second phosphor having different compositions may be combined.

Further, it is preferable that the phosphor contained in the second light emitter be adjusted such that the wavelength of emission peak thereof is longer than the wavelength of emission peak of the first light emitter, or 420 nm to 500 nm. This allows efficient emission of white light.

Structure of light-emitting device

The light-emitting device of the present invention is not particularly limited as to its structure as long as it includes the above-described first light emitter and second light emitter, but is usually composed of the above-described first light emitter and second light emitter disposed on an appropriate frame. In this case, they are disposed such that the second light emitter is excited with light emission by the first light emitter to emit light, and light emission by the first light emitter and/or light emission by the second light emitter is taken out.

In addition to the above-described first light emitter, second light emitter, and frame, a sealing material is usually used. Specifically, the sealing material is employed for the purpose of dispersing the above-described first phosphor and/or second phosphor therein and composing the second light emitter, or bonding the first light emitter, second light emitter, and frame together.

Examples of the sealing material usually used herein include thermoplastic resins, thermosetting resins, and photocurable resins. Specific examples thereof include metaacrylic resins such as polymethyl methacrylate; styrene resins such as polystyrene and styrene-acrylonitrile copolymer; polycarbonate resins; polyester resins; phenoxy resins; butyral resins; polyvinyl alcohols; cellulose resins such as ethyl cellulose, cellulose acetate, and cellulose acetate butylate; epoxy resins; phenolic resins; and silicone resins. Other examples include a solution prepared through hydrolysis polymerization of a solution containing an inorganic material such as a metal alkoxide, ceramic precursor polymer, or metal alkoxide by a sol-gel method, or an inorganic material in which these combinations are fixed, such as an inorganic material having a siloxane bond.

Embodiment of light-emitting device

The light-emitting device of the present invention is illustrated below in further detail with reference to specific embodiments. However, the present invention is not limited to the following embodiments, and may be optionally deformed without departing from the scope of the present invention.

The light-emitting device of the present invention is a light-emitting device having a high emission intensity, and is usable as a light source for an image display device such as a color display or a lighting system such as a surface emitting lighting device.

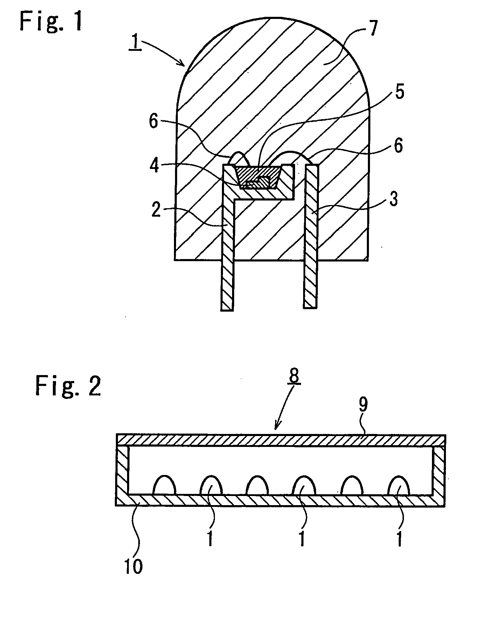

Fig. 1 is a schematic cross-sectional view of an example of the light-emitting device of the present invention having a first light emitter (a light emitter emit light having a wavelength of 420 nm to 500 nm) and a second light emitter. Fig. 2 is a schematic cross-sectional view of an example of a surface emitting lighting system including the light-emitting device shown in Fig. 1. In Figs. 1 and 2, numeral 1 designates a light-emitting device, numeral 2 designates a mount lead, numeral 3 designates an inner lead, numeral 4 designates a first light emitter, numeral 5 designates a phosphor-containing section as a second light emitter, numeral 6 designates a conductive wire, numeral 7 designates a mold member, numeral 8 designates a surface emitting lighting device, numeral 9 designates a diffusion plate, and numeral 10 designates a retaining case.

The light-emitting device of the present invention 1 is, for example as shown in Fig. 1, in the form of a common shell. The first light emitter 4 composed of a GaN-based blue light-emitting diode or the like is bonded to the inside of the upper cup of the mount lead 2. The phosphor of the present invention and, as necessary, other phosphor (for example, a red light-emitting phosphor) are mixed with and dispersed in a sealing material such as an epoxy resin, an acrylic resin, or a silicone resin, and poured into the cup to form the phosphor-containing section 5. The phosphor-containing section 5 covers and fixes the first light emitter 4. On the other hand, the first light emitter 4 and the mount lead 2, and the first light emitter 4 and the inner lead 3 are respectively communicated with each other through the conductive wires 6 and 6, and the whole is covered and protected by the mold member 7 composed of an epoxy resin and others.

Fig. 2 shows the surface emitting lighting system 8 including the light-emitting device 1. A number of the light-emitting device 1 is disposed on the bottom of the square retaining case 10 having opaque inner surfaces such as white smooth surfaces, with a power supply, a circuit, and others (not shown) for driving the light-emitting device 1 provided on the outside of the case. In order to equalize light emission, the diffusion plate 9 such as a milky white acryl plate is fixed to the portion corresponding to the cap of the retaining case 10.

The surface emitting lighting device 8 is driven to apply a voltage to the first light emitter 4 of the light-emitting device 1 thereby emitting blue light and others. The emitted light is partially absorbed in the phosphor of the present invention, which serves as a wavelength converting material, and in other phosphors, which are optionally added, in the phosphor-containing section 5, converted into longer wavelength light, and mixed with blue light and others, which have not absorbed into the phosphor, to provide light emission having a high luminance. The light passes through the diffuser plate 9 and outgoes toward the top of the drawing, thereby providing illuminating light having a uniform brightness in the plane of the diffusion plate 9 of the retaining case 10.

the first light emitter 4 is a light source for emitting the excitation light for the phosphor contained in the phosphor-containing section 5, and also a light source for emitting light as one component of light release from the light-emitting device 1. More specifically, a portion of light emitted from the first light emitter 4 is absorbed in the light-emitting substance in the phosphor-containing section 5 as excitation light, and other portion is released from the light-emitting device 1.

The phosphor-containing section 5 in the light-emitting device 1 has the following effects. More specifically, light from the first light emitter and light from the phosphor as the second light emitter are usually oriented to all directions, but the direction of light can be uniformed to a degree by dispersing the phosphor powder as the second light emitter in the sealing material such that the light is partially reflected when going out of the phosphor-containing section 5. Accordingly, the second light emitter is preferably a dispersion of the above-described phosphor powder in the sealing material which moderately guides light to efficient directions. In addition, when the phosphor is dispersed in the phosphor-containing section, the total irradiation area of the second light emitter irradiated by light from the first light emitter increases, which is beneficial for the increase of the emission intensity from the second light emitter.

Examples of the sealing material usable in the phosphor-containing section include various resins such as silicone resins, modified silicone resins, epoxy resins, polyvinyl-based resins, polyethylene-based resins, polypropylene-based resins, and polyester-based resins, which may be used alone or in combination of two or more of them. Among them, epoxy resins and silicone resins are preferable from the viewpoint of good dispersibility of the phosphor powder. As necessary, a silica-based thickening agent (AEROSIL, registered trademark) is preferably added at a specific surface area of about 150 $m^2$/g to 300 $m^2$/g. In cases where the phosphor powder is dispersed in the sealing material, the weight proportion of the phosphor powder to the total of the phosphor powder and the sealing material is usually 5% by weight, preferably 10% by weight, in addition, usually 50% by weight or less, and preferably 30% by weight or less. If the phosphor exceeds the range, the emission efficiency may decrease because of the aggregation of the phosphor powder, and if below the range, the emission efficiency may also decrease because of the absorption or scattering of light by the resin.

In the present invention, it is preferable that a surface emitting light emitter, particularly a surface emitting GaN-based laser diode be used as the first light emitter to increase the emission efficiency of the whole light-emitting device. The surface emitting light emitter is a light emitter which provides strong light emission in the surface direction of the layer. In a surface emitting GaN-based laser diode, light emission of the luminescent layer can be stronger in the surface direction than the edge direction by controlling the crystal growth of the luminescent layer and others, and properly designing the reflecting layer and others. Through the use of a surface emitting one, luminescent cross-sectional area per unit amount of light emission is increased in comparison with that emits light from the edge of the luminescent layer. Accordingly, when the phosphor as the second light emitter is irradiated with the light, the irradiation area is remarkably increased with the same amount of light, which improves the irradiation efficiency, and thus allows to obtain stronger light emission from the phosphor as the second light emitter.

Further, the phosphor as the second light emitter may contain, in addition to the above-described phosphor of the present invention, more specifically the phosphor having a specific composition expressed by the general formula [1], and the phosphor having a specific median diameter $D_{50}$ and object color, a plurality of phosphors having different composition ratios, or a combination of phosphors other than the phosphor of the present invention. Through the use of an appropriate combination, a wider range of white region and a higher color rendering index are achieved. The other phosphor is not particularly limited, and may be a phosphor which emits light complementary to the light from the first light emitter, or a phosphor which emits green and red light to produce white light together with the light from the first light emitter.

Further, in the light-emitting device of the present invention, in cases where particularly a surface emitting emitter is used as the first light emitter, the second light emitter is preferably a film. More specifically, the light from the surface emitting light emitter has a sufficiently large cross-sectional area, therefore, when the second light emitter is a film oriented to the direction of the cross section of the light, the irradiation cross-sectional area of the phosphor irradiated by the first light emitter per unit volume of the phosphor increases, which further increases the emission intensity of the phosphor.

In cases where the first light emitter is of surface emitting type and the second light emitter is of film type, the film form second light emitter is preferably in direct contact with the luminous surface of the first light emitter. The term "contact" used herein refers to the state in which the first light emitter and the second light emitter are in close contact with each other with no intervention of air or gas. As a result, the light amount loss caused by the effusion of the light from the first light emitter reflected on the film surface of the second light emitter is avoided, which improves the emission efficiency of the whole device.

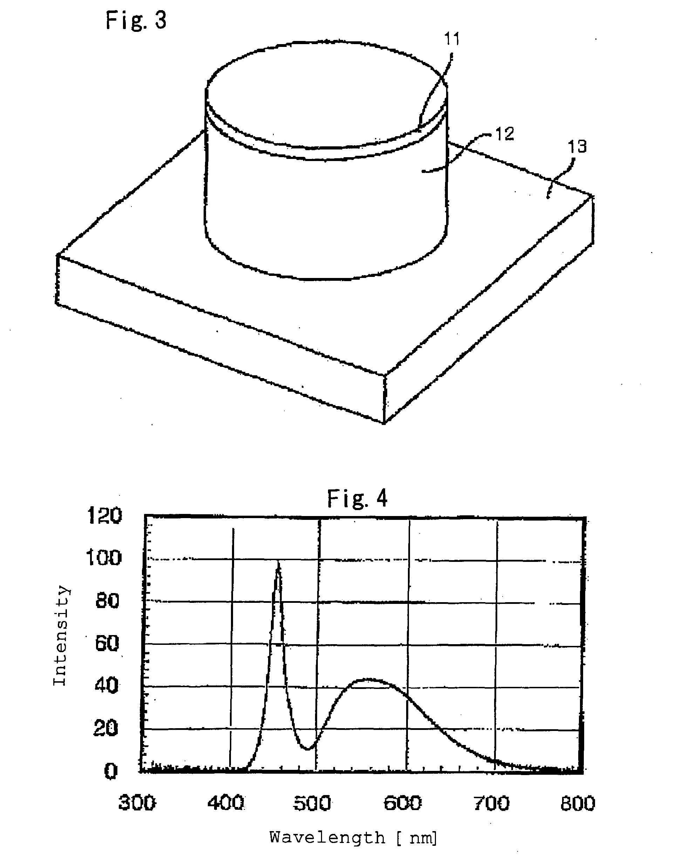

Fig. 3 is a schematic perspective view of an example of a light-emitting device including a first light emitter of surface emitting type, and a second light emitter of film type. In Fig. 3, numeral 11 indicates a film form second light emitter having the above-described phosphor, numeral 12 indicates a surface emitting GaN-based LD as the first light emitter, and numeral 13 indicates a substrate. In order to bring them into contact with each other, the surfaces of the LD as the first light emitter 12 and the second light emitter 11, which have been independently prepared, may be attached together with an adhesive other means, or the second light emitter 11 may be deposited (formed) on the luminous surface of the LD 12. As a result of these measures, the LD 12 and the second light emitter 11 are in contact with each other.

Examples

The present invention is further illustrated below, but the present invention is not limited to the following examples without departing from the scope of the present invention.

In the below-described examples and comparative examples, various evaluations were conducted by the following procedures.

<Excitation spectrum>

The measurement was conducted using a F-4500 fluorescence spectrophotometer manufactured by Hitachi, Ltd. With changing the excitation wavelength, the emission intensity at the peak wavelength of the emission spectrum of the phosphors prepared in examples and comparative examples was monitored. The measurement was conducted with an excitation side slit/fluorescence side slit of 2.5 nm/10.0 nm.

Further, the FWHM of the excitation spectrum was determined from the measured excitation spectrum.

<Average variation rate of the emission intensity>

The excitation spectrum for the emission peak wavelength of the phosphors was measured using a fluorescence spectrophotometer ("F4500" manufactured by Hitachi, Ltd.). The variation rate of the emission intensity at excitation wavelength intervals of 1 nm was determined by the following formula, and the dependence on the excitation wavelength was expressed by the average variation rate of the emission intensity at wavelengths 420 nm to 480 nm.

$$\text{Variation rate of emission intensity} = [(I(\lambda+1) - I(\lambda))/I(\lambda)]^2$$

<Emission spectrum, color coordinate, and luminance>

In a fluorescence measurement apparatus manufactured by JASCO Corporation, a 150 W xenon lamp was used as the excitation light source. The light of the xenon lamp was passed through a grating spectrograph with a focal distance of 10 cm, and the light of 450 nm to 475 nm were exclusively radiated on the phosphor through optical fibers. The light generated by irradiation with the excitation light was dispersed with a grating spectrograph with a focal distance of 25 cm, and the emission intensity at wavelengths from 300 nm to 800 nm was measured using "C7041", a CCD multichannel detector manufactured by Hamamatsu Photonics K. K. Subsequently, an emission spectrum was obtained through signal processing such as sensitivity correction or the like by a personal computer.

From the data in the wavelength range of 480 nm to 800 nm in the emission spectrum, color coordinates x and y were calculated according to the XYZ color system defined in JIS Z8701.

In addition, from the stimulus value Y according to the XYZ color system calculated according to JIS Z8724, a relative brightness was calculated with the stimulus value Y of the phosphor in the below-described Comparative Example 4 as 100%.

The color coordinate and brightness were measured with the excitation blue light removed.

<Weight average median diameter $D_{50}$>

Before the measurement, the sample was ultrasonically dispersed using an ultrasonic disperser (manufactured by Kaijo Corporation) for 25 seconds at a frequency of 19 KHz and an ultrasonic intensity of 5 W. In order to prevent reaggregation, a small amount of surfactant was added to the dispersion liquid.

The weight-average median diameter $D_{50}$ was measured with a laser diffraction particle size distribution analyzer (manufactured by Horiba, Ltd.).

<Average circularity>

The sample was dispersed in the same manner as the above-described measurement of the weight-average median diameter $D_{50}$, and then measured with a flow-type particle image analyzer ("FPIA-2100" manufactured by Sysmex Corporation).

<Chemical composition>

The sample was completely dissolved in a platinum crucible using a strong acid, and analyzed with "JY 38S", an ICP chemical analyzer manufactured by Jovin Yvon Emission Instruments.

<Object color>

The phosphor powder was charged into a cell having an inside diameter of 10 mm, and subjected to colorimetry via a 1-mm-thick synthetic quartz plate using a differential colorimeter (Chroma Meter "CR-300" manufactured by Konica Minolta Holdings, Inc.) at a standard light D65 irradiation mode, thus the L*, a*, and b* values were determined.

<Absorbance>

As a spectrophotometer, "MCPD2000" manufactured by Otsuka Electronics Co., Ltd. was used in combination with a 1-inch integrating sphere, and the absorbance was determined by the above-described method.

<Entire luminous flux>

As described below, a light-emitting device having the structure as shown in Fig. 1 was prepared, and the measurement was conducted using the combination of a spectrometer manufactured by Ocean Photonics, Inc. and a 1-inch integrating sphere.

An LED emitting light having a wavelength of 453 nm or 463 nm was used as the first light emitter 4. A sealing material composed of an epoxy resin (EPICOAT (registered trademark) 828EX manufactured by Japan Epoxy Resins Co., Ltd.)

and a curing agent at a ratio of 1:1 was mixed with 5% by weight of a phosphor to prepare a phosphor slurry (phosphor-containing composition). The phosphor slurry thus obtained was injected into the recess on the mount lead 2, and cured to form the phosphor-containing section 5.

The values of the entire luminous flux in examples and comparative examples are data obtained when a LED was made with the excitation wavelength and the coating weight of the phosphor adjusted such that a white color (color temperature 7000 K, x = 0.31 $\pm$ 0.03) was produced. The usage of the phosphor was 0.02 mg to 0.1 mg for one shell-type LED. When the particle size of the phosphor was large, a silica-based thickening agent (specific surface area 150 m$^2$/g to 300 m$^2$/g, AEROSIL) was added to prevent precipitation and deposition of the phosphor particles. The light-emitting device thus prepared was driven at 20 mA and room temperature (about 24°C). The result were expressed as relative values with the eitire luminous flux in Comparative Example 1 as 100.

<QD>

The QD value of the phosphors according to the present invention used in the following EXAMPLES 1 to 19 was in the range of 0.19 to 0.2.

EXAMPLES 1 to 4, COMPARATIVE EXAMPLE 1

The following raw materials were weighed to give the charges listed in Table 1.
Yttrium oxide $Y_2O_3$ (manufactured by Shin-Etsu Chemical Co., Ltd., purity 99.99%)
Cerium oxide $CeO_2$ (manufactured by Shin-Etsu Chemical Co., Ltd., purity 99.99%)
Terbium oxide $Tb_4O_7$ (manufactured by Shin-Etsu Chemical Co., Ltd., purity 99.99%)
Aluminum oxide $Al_2O_3$ ($\alpha$-type, manufactured by Sumitomo Chemical Co., Ltd., purity 99.99%)
Barium fluoride $BaF_2$ (manufactured by Kanto Chemical Co., Inc.)

In the next place, the weighed raw materials were charged into a 2-L polyethylene wide-mouthed container, and mixed by rotating for three hours together with 1 kg of nylon-coated iron balls. The raw material mixture was charged into an alumina crucible, and fired under a normal pressure, at 1450°C, for 6 hours in a nitrogen-hydrogen mixed gas flow containing 4 vol% of hydrogen. The fired product which had been tinged with yellow by the firing was lightly cracked. Subsequently, the fired product was washed with 1.5 mol/l of hydrochloric acid to be dispersed in the form of particles, and then sufficiently washed with water. Thereafter, classification treatment was conducted to obtain the intended phosphor. The obtained phosphor was dispersed in water, to which an alkali metal phosphate solution and a calcium salt solution were added and stirred to coat the surface of phosphor particles with calcium phosphate. The phosphor was isolated by filtration, dried, and then sieved through a nylon mesh (opening size 50 μm) to obtain a phosphor having favorable dispersibility.

Tables 1 and 2 lists the results of the measurements made on the obtained phosphors for the composition of the charged raw materials, chemical composition of the phosphor, wavelength of emission peak, average variation rate of the emission intensity and FWHM of the excitation spectrum, median diameter $D_{50}$, average circularity, object color (L*, a*, and b*), absorbance (light absorption efficiency), color coordinates, brightness, and entire luminous flux. The phosphor of Example 1 was measured for its emission spectrum, and the result is shown in Fig. 4.

In Table 2, Comparative Example 1 indicated with "*" in the section of the entire luminous flux was measured using an LED having a wavelength of 453 nm. Examples 1 to 3 with no "*" were measured using an LED having a wavelength of 463 nm. The same applies to Tables 4, 6, 8, and 10.

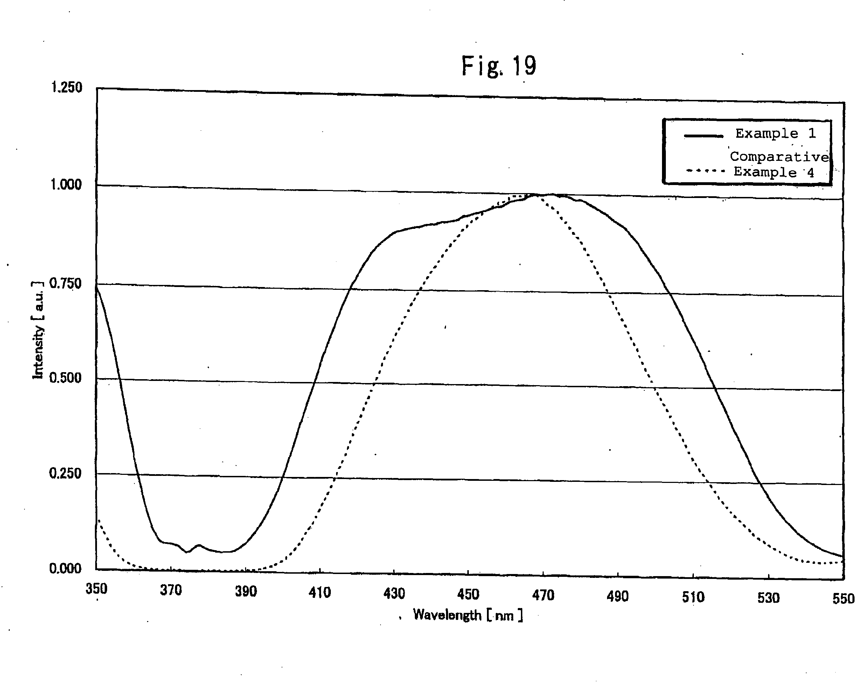

The excitation spectrums in Example 1 and Comparative Example 4 are as shown in Fig. 19.

[Table 1]

| | Charged raw materials | | | | | M/Ln1-a-bCeaTbb (Molar ratio) | Composition of phosphor |
|---|---|---|---|---|---|---|---|
| | $Y_2O_3$ (g) | $CeO_2$ (g) | $Tb_4O_7$ (g) | $Al_2O_3$ (g) | $BaF_2$ (g) | | |
| Example 1 | 311.65 | 20.67 | 22.45 | 267.65 | 49.79 | 5.25/3 | $Y_{2.76}Ce_{0.12}Tb_{0.12}Al_{5.0}O_{12}$ |
| Example 2 | 311.65 | 20.67 | 22.45 | 265.10 | 49.59 | 5.20/3 | $Y_{2.76}Ce_{0.12}Tb_{0.12}Al_{5.0}O_{12}$ |
| Example 3 | 311.65 | 20.67 | 22.45 | 262.55 | 49.39 | 5.15/3 | $Y_{2.76}Ce_{0.12}Tb_{0.12}Al_{5.0}O_{12}$ |
| Example 4 | 311.65 | 20.67 | 22.45 | 260.00 | 49.18 | 5.10/3 | $Y_{2.76}Ce_{0.12}Tb_{0.12}Al_{5.0}O_{12}$ |

(continued)

| | Charged raw materials | | | | | M/Ln1-a-bCeaTbb (Molar ratio) | Composition of phosphor |
|---|---|---|---|---|---|---|---|
| | $Y_2O_3$ (g) | $CeO_2$ (g) | $Tb_4O_7$ (g) | $Al_2O_3$ (g) | $BaF_2$ (g) | | |
| Comparative Example 1 | 311.65 | 20.67 | 22.45 | 254.90 | 48.77 | 5.00/3 | $Y_{2.76}Ce_{0.12}Tb_{0.12}Al_{5.0}O_{12}$ |

[Table 2]

| | Wavelength of emission peak (nm) | Variation rate of emission intensity (average at wavelengths 420 to 480 nm) | FWHM of excitation spectrum | Color coordinates | | Brightness | Absorbance $\alpha$ | Median diameter $D_{50}$ ($\mu$m) | Average circularity | Object color | | | luminous flux (%) |
| | | | | x value | y value | | | | | L* | a* | b* | |
|---|---|---|---|---|---|---|---|---|---|---|---|---|---|
| Example 1 | 562 | 0.42 | 109 | 0.464 | 0.523 | 147 | 0.73 | 24.3 | 0.93 | 104.9 | -10.0 | 113.6 | 102 |
| Example 2 | 561 | 0.49 | 107 | 0.459 | 0.526 | 146 | 0.73 | 21.7 | 0.93 | 105.4 | -11.7 | 113.3 | 103 |
| Example 3 | 558 | 0.60 | 105 | 0.455 | 0.530 | 149 | 0.72 | 21.5 | 0.93 | 104.2 | -12.9 | 110.0 | 105 |
| Example 4 | 556 | 0.73 | 102 | 0.454 | 0.530 | 150 | 0.72 | 20.2 | 0.93 | 105.5 | -13.7 | 118.2 | 103 |
| Comparative Example 1 | 549 | 1.35 | 94 | 0.439 | 0.541 | 152 | 0.70 | 13.6 | 0.84 | 102.9 | -18.8 | 101.8 | *100 |

EP 1 854 863 A1

20

COMPARATIVE EXAMPLES 2 to 4

Phosphors were prepared and evaluated in the same manner as Examples 1 to 4 except that the charge of the raw materials was changed as listed in Table 3, wherein $\alpha$-$Al_2O_3$ was added according to the stoichiometric composition, and the firing was conducted under a normal pressure, at 1400°C, for 2 hours in a nitrogen-hydrogen mixed gas flow containing 4 vol% of hydrogen. The results are listed in Tables 3 and 4.

As the Gd source raw material in Comparative Example 4, gadolinium oxide $Gd_2O_3$ (manufactured by Shin-Etsu Chemical Co., Ltd., purity 99.99%) was used.

All of the phosphors thus obtained had a median diameter $D_{50}$ of 10 $\mu$m or less. In comparison with Examples 1 to 4 and Comparative Example 4 containing the same amount of activator, Comparative Example 4 was inferior the brightness and entire luminous flux.

[Table 3]

| | Charged raw materials | | | | | | $M/Ln_{1-a-b}Ce_aTb_b$ (Molar ratio) | Composition of phosphor |
|---|---|---|---|---|---|---|---|---|
| | $Y_2O_3$ (g) | $Gd_2O_3$ (g) | $CeO_2$ (g) | $Tb_4O_7$ (g) | $Al_2O_3$ (g) | $BaF_2$ (g) | | |
| Comparative Example 2 | 325.18 | 0 | 15.85 | 5.61 | 254.9 | 48.1 | 5/3 | $Y_{2.88}Ce_{0.09}Tb_{0.03}Al_5O_{12}$ |
| Comparative Example 3 | 254.05 | 0 | 52.83 | 84.11 | 254.9 | 51.67 | 5/3 | $Y_{2.25}Ce_{0.3}Tb_{0.45}Al_5O_{12}$ |
| Comparative Example 4 | 237.11 | 141.41 | 21.13 | 0 | 254.9 | 52.36 | 5/3 | $Y_{2.1}Gd_{0.78}Ce_{0.12}Al_5O_{12}$ |

[Table 4]

| | Wavelength of emission peak (nm) | Variation rate of emission intensity (average at wavelengths 420 to 480 nm) | FWHM of excitation spectrum | Chromaticity coordinates | | Brightnes s | Absorbance $\alpha$ | Median diameter Median $D_{50}$ ($\mu$m) | Average circularity | Object color | | | Entire luminous flux (%) |
| --- | --- | --- | --- | --- | --- | --- | --- | --- | --- | --- | --- | --- | --- |
| | | | | x value | y value | | | | | L* | a* | b* | |
| Comparative Example 2 | 550 | 1.35 | 92 | 0.435 | 0.540 | 135 | 0.61 | 6.2 | 0.75 | 106.0 | -17.1 | 87.8 | *95 |
| Comparative Example 3 | 558 | 2.12 | 91 | 0.458 | 0.525 | 132 | 0.60 | 6.0 | 0.74 | 104.7 | -13.0 | 84.1 | 93 |
| Comparative Example 4 | 557 | 5.76 | 77 | 0.450 | 0.527 | 100 | 0.50 | 6.6 | 0.75 | 104.0 | -13.0 | 55.4 | 70 |

EXAMPLES 5 to 11

Phosphors were prepared and evaluated in the same manner as Examples 1 to 4 except that the charge of the raw materials was changed as listed in Table 5, and the firing was conducted under a normal pressure, at 1550°C, for 2 hours in a nitrogen-hydrogen mixed gas flow containing 4 vol% of hydrogen. The results are listed in Tables 5 and 6. As the Lu source raw material in Examples 6 to 11, lutetium oxide $Lu_2O_3$ (manufactured by Shin-Etsu Chemical Co., Ltd., purity 99.99%) was used.

The results on Examples 5 to 11 indicate that the emission wavelength of the phosphors shifted to the short wavelength side by substituting Y with Lu, and the brightness and entire luminous flux were improved by adding an appropriate amount of $Lu_2O_3$. In addition, when the $Lu_2O_3$ content in the composition of charged raw materials was 0.6 or more, the median diameter $D_{50}$ tended to decrease, and the emission wavelength was slightly shifted to the short wavelength side.

[Table 5]

| | Charged raw materials | | | | | | $M/Ln_{1-a-b}Ce_aTb_b$ (Molar ratio) | Composition of phosphor |
|---|---|---|---|---|---|---|---|---|
| | $Y_2O_3$ (g) | $Lu_2O_3$ (g) | $CeO_2$ (g) | $Tb_4O_7$ (g) | $Al_2O_3$ (g) | $BaF_2$ (g) | | |
| Example 5 | 325.18 | 0 | 15.85 | 5.61 | 267.65 | 36.9 | 5.25/3 | $Y_{2.88}Ce_{0.09}Tb_{0.03}Al_5O_{12}$ |
| Example 6 | 318.41 | 11.94 | 15.85 | 5.61 | 267.65 | 37.2 | 5.25/3 | $Y_{2.82}Lu_{0.06}Ce_{0.09}Tb_{0.03}Al_5O_{12}$ |
| Example 7 | 315.02 | 17.91 | 15.85 | 5.61 | 267.65 | 37.3 | 5.25/3 | $Y_{2.79}Lu_{0.09}Ce_{0.09}Tb_{0.03}Al_5O_{12}$ |
| Example 8 | 308.24 | 29.85 | 15.85 | 5.61 | 267.65 | 37.6 | 5.25/3 | $Y_{2.73}Lu_{0.15}Ce_{0.09}Tb_{0.03}Al_5O_{12}$ |
| Example 9 | 291.31 | 59.7 | 15.85 | 5.61 | 267.65 | 38.4 | 5.25/3 | $Y_{2.58}Lu_{0.3}Ce_{0.09}Tb_{0.03}Al_5O_{12}$ |
| Example 10 | 257.43 | 119.4 | 15.85 | 5.61 | 267.65 | 40 | 5.25/3 | $Y_{2.28}Lu_{0.6}Ce_{0.09}Tb_{0.03}Al_5O_{12}$ |
| Example 11 | 212.27 | 199 | 15.85 | 5.61 | 267.65 | 42 | 5.25/3 | $Y_{1.88}Lu_{1.0}Ce_{0.09}Tb_{0.03}Al_5O_{12}$ |

[Table 6]

| | Wavelength of emission peak (nm) | Variation rate of emission intensity (average at wavelengths 420 to 480 nm) | FWHM of excitation spectrum | Color coordinates | | Brightness | Absorbance $\alpha$ | Median diameter $D_{50}$ ($\mu$m) | Average circularity | Object color | | | entire luminous flux (%) |
| | | | | x value | y value | | | | | L* | a* | b* | |
|---|---|---|---|---|---|---|---|---|---|---|---|---|---|
| Example 5 | 559 | 0.67 | 96 | 0.451 | 0.533 | 155 | 0.71 | 18.4 | 0.93 | 106.9 | -15.1 | 118.1 | 103 |
| Example 6 | 557 | 0.70 | 98 | 0.450 | 0.534 | 160 | 0.74 | 18.0 | 0.93 | 106.7 | -15.5 | 110.0 | 105 |
| Example 7 | 557 | 0.73 | 99 | 0.449 | 0.535 | 158 | 0.72 | 17.7 | 0.92 | 104.8 | -14.8 | 110.0 | 104 |
| Example 8 | 557 | 0.93 | 97 | 0.446 | 0.537 | 156 | 0.71 | 16.3 | 0.91 | 104.9 | -15.7 | 105.0 | 103 |
| Example 9 | 556 | 0.93 | 97 | 0.444 | 0.538 | 155 | 0.70 | 16.2 | 0.90 | 106.0 | -16.8 | 102.0 | 102 |
| Example 10 | 552 | 0.94 | 97 | 0.440 | 0.540 | 155 | 0.70 | 15.3 | 0.90 | 107.0 | -18.0 | 100.0 | 101 |
| Example 11 | 550 | 0.97 | 96 | 0.425 | 0.545 | 145 | 0.65 | 14.0 | 0.86 | 105.0 | -20.0 | 92.0 | *100 |

EXAMPLES 12 to 15

Phosphors were prepared and evaluated in the same manner as Examples 1 to 4 except that the charge of the raw materials was changed as listed in Table 7, and the firing was conducted under a normal pressure, at 1550°C, for 2 hours in a nitrogen-hydrogen mixed gas flow containing 4 vol% of hydrogen. The results are listed in Tables 7 and 8. Examples 12 to 15 used different amounts of Ce. The results indicate that, with the decrease of the Ce amount, the emission wavelength of the phosphor shifted to the short wavelength side, and the value of b* got smaller and the object color changed to light yellow.
In addition, regarding the excitation wavelength for the phosphors of Examples 12 to 15 having a short emission wavelength, 453 nm was preferable to 465 nm to obtain light closer to white.
[Table 7]

| | Charged raw materials | | | | $M/Ln_{1-a-b}Ce_aTb_b$ (Molar ratio) | Composition of phosphor |
|---|---|---|---|---|---|---|
| | $Y_2O_3$ (g) | $CeO_2$ (g) | $Al_2O_3$ (g) | $BaF_2$ (g) | | |
| Example 12 | 335.34 | 5.28 | 267.65 | 36.6 | 5.25/3 | $Y_{2.97}Ce_{0.03}Al_5O_{12}$ |
| Example 13 | 331.96 | 10.57 | 267.65 | 36.6 | 5.25/3 | $Y_{2.94}Ce_{0.06}Al_5O_{12}$ |
| Example 14 | 330.26 | 13.21 | 267.65 | 36.7 | 5.25/3 | $Y_{2.925}Ce_{0.075}Al_5O_{12}$ |
| Example 15 | 328.57 | 15.85 | 267.65 | 36.7 | 5.25/3 | $Y_{2.91}Ce_{0.09}Al_5O_{12}$ |

[Table 8]

| | Wavelength of emission peak (nm) | Variation rate of emission intensity (average at wavelengths 420 to 480 nm) | FWHM of excitation spectrum | Color coordinates | | Brightness | Absorbance $\alpha$ | Median diameter $D_{50}$ ($\mu$m) | Average circularity | Object color | | | Entire luminous flux (%) |
|---|---|---|---|---|---|---|---|---|---|---|---|---|---|
| | | | | x value | y value | | | | | L* | a* | b* | |
| Example 12 | 543 | 0.98 | 96 | 0.416 | 0.556 | 153 | 0.73 | 19.0 | 0.91 | 107.0 | -23.7 | 90.0 | *105 |
| Example 13 | 550 | 1.00 | 95 | 0.430 | 0.548 | 160 | 0.75 | 20.0 | 0.91 | 107.0 | -20.2 | 105.0 | *109 |
| Example 14 | 553 | 0.95 | 96 | 0.440 | 0.540 | 160 | 0.76 | 20.4 | 0.92 | 106.5 | -18.0 | 105.0 | 109 |
| Example 15 | 555 | 0.99 | 96 | 0.448 | 0.535 | 158 | 0.76 | 20.5 | 0.92 | 106.0 | -16.0 | 109.7 | 106 |

EXAMPLES 16 to 19

Phosphors were prepared and evaluated in the same manner as Examples 1 to 4 except that the charge of the raw materials was changed as listed in Table 9, and the firing was conducted under a normal pressure, at 1550°C, for 2 hours in a nitrogen-hydrogen mixed gas flow containing 4 vol% of hydrogen. The results are listed in Tables 9 and 10. As the Ga source in Examples 17 to 19, gallium oxide $Ga_2O_3$(manufactured by Mitsui Mining & Smelting Co., Ltd., purity 99.99%), and the Lu source in Example 19, lutetium oxide $Lu_2O_3$ (manufactured by Shin-Etsu Chemical Co., Ltd., purity 99.99%) was used.
The results on Examples 16 to 19 indicate that the emission peak of the phosphors shifted to the short wavelength side by substituting A1 with Ga.
[Table 9]

| | Charged raw materials | | | | | | $M/Ln_{1-a-b}Ce_aTb_b$ (Molar ratio) | Composition of phosphor |
|---|---|---|---|---|---|---|---|---|
| | $Y_2O_3$ (g) | $Lu_2O_3$ (g) | $CeO_2$ (g) | $Al_2O_3$ (g) | $Ga_2O_3$ (g) | $BaF_2$ (g) | | |
| Example 16 | 327.55 | 0 | 17.43 | 267.65 | 0 | 36.76 | 5.25/3 | $Y_{2.901}Ce_{0.099}Al_5O_{12}$ |
| Example 17 | 327.55 | 0 | 17.43 | 242.16 | 46.86 | 38 | 5.25/3 | $Y_{2.901}Ce_{0.099}Al_{4.5}Ga_{0.5}O_{12}$ |
| Example 18 | 327.55 | 0 | 17.43 | 216.67 | 93.72 | 39.3 | 5.25/3 | $Y_{2.901}Ce_{0.099}Al_4Ga_1O_{12}$ |
| Example 19 | 320.78 | 11.94 | 17.43 | 234.51 | 65.6 | 39 | 5.3/3 | $Y_{2.841}Lu_{0.06}Ce_{0.099}Al_{4.3}Ga_{0.7}O_{12}$ |

EP 1 854 863 A1

[Table 10]

| | Wavelength of emission peak (nm) | Variation rate of emission intensity (average at wavelengths 420 to 480 nm) | FWHM of excitation spectrum | Color coordinates | | Brightness | Absorbance $\alpha$ | Median diameter $D_{50}$ ($\mu$m) | Average circularity | Object color | | | Entire luminous flux (%) |
| | | | | x value | y value | | | | | L* | a* | b* | |
|---|---|---|---|---|---|---|---|---|---|---|---|---|---|
| Example 16 | 557 | 0.61 | 99 | 0.452 | 0.532 | 153 | 0.72 | 20.1 | 0.92 | 105.6 | -14.2 | 108.3 | 101 |
| Example 17 | 552 | 0.34 | 102 | 0.438 | 0.541 | 160 | 0.76 | 20.7 | 0.92 | 106.9 | -19.5 | 104.7 | *11 |
| Example 18 | 550 | 0.40 | 97 | 0.420 | 0.552 | 156 | 0.73 | 17.2 | 0.91 | 107.5 | -24.2 | 97.0 | *112 |
| Example 19 | 552 | 0.45 | 98 | 0.431 | 0.546 | 158 | 0.74 | 17.7 | 0.91 | 107.8 | -21.6 | 107.0 | *110 |

The present invention has been described in detail with reference to specific embodiments, but it is evident to those skilled in the art that various modifications are possible without departing from the intent of the present invention. The present application is based on Japanese Patent Application No. 2005-053676 submitted on February 28, 2005 and the entirety thereof is incorporated by reference.

**Claims**

1. A phosphor comprising a crystal phase having a chemical composition expressed by the following general formula [1], and providing an average variation rate of the emission intensity of 1.3 or less upon excitation with light having a peak in the wavelength range of 420 nm to 480 nm, the variation rate of the emission intensity being calculated by the following general formula [2]:

$$(Ln_{1-a-b}Ce_aTb_b)_3M_5O_{12} \qquad [1]$$

wherein Ln is at least one element selected from the group consisting of Y, Gd, Sc, Lu, and La, M represents at least one element selected from the group consisting of Al, Ga, and In, and a and b satisfy $0.001 \leq a \leq 0.3$ and $0 \leq b \leq 0.5$, respectively.

$$\text{Variation rate of emission intensity} = [(I(\lambda + 1) - I(\lambda))/I(\lambda)]^2 \quad [2]$$

wherein $I(\lambda)$ is the emission intensity of the phosphor at an excitation wavelength of $\lambda$ nm, and $I(\lambda + 1)$ is the emission intensity of the phosphor at an excitation wavelength of $(\lambda + 1)$ nm.

2. The phosphor according to Claim 1, wherein the average variation rate of the emission intensity is 1.1 or less.

3. The phosphor according to Claim 1, wherein the weight-average median diameter $D_{50}$ is 10 $\mu$m or more.

4. The phosphor according to Claim 1, wherein the weight-average median diameter $D_{50}$ is 14 $\mu$m or more.

5. The phosphor according to Claim 1, which comprises at least Y as Ln in the general formula [1], and at least A1 as M in the general formula [1] .

6. The phosphor according to Claim 1, wherein the values a and b in the general formula [1] satisfy $0.02 \leq a \leq 0.15$, and $0.02 < b \leq 0.5$, respectively.

7. The phosphor according to Claim 5, which comprises at least Y and Lu as Ln in the general formula [1].

8. The phosphor according to Claim 7, wherein the Lu content is from 0.03 to 1. The Lu content corresponds to q when the general formula [1] is expressed by the following general formula [1A] :

$$Y_pLu_qCe_{3a}Tb_{3b}M_5O_{12} \qquad [1A]$$

wherein in the general formula [1A], M, a, and b are the same as those in the general formula [1], p and q represent the Y content and Lu content, respectively, and $Y_pLu_q = Ln_{3-3a-3b}$.

9. The phosphor according to Claim 5, which comprises at least Al and Ga as M in the general formula [1].

10. The phosphor according to Claim 9, wherein the Ga content is from 0.2 to 3, the Ga content corresponding to r when the general formula [1] is expressed by the following general formula [1B] :

$$(Ln_{1-a-b}Ce_aTb_b)_3M'_{5-r}Ga_rO_{12} \qquad [1B]$$

wherein in the general formula [1B], Ln, a, and b are the same as those in the general formula [1], M' represents M other than Ga (M is the same as that in the general formula [1]), and $M'_{5-r}Ga_r = M_5$.

11. The phosphor according to Claim 1, wherein the average circularity is 0.86 or more.

12. The phosphor according to Claim 1, wherein the object color satisfies $L^* \geq 90$, $a^* \leq -7$, and $b^* \geq 55$ under a color system of $L^*$, $a^*$, and $b^*$.

13. A phosphor which has an object color satisfying $L^* \geq 90$, $a^* \leq -7$, and $b^* \geq 55$ under a color system of $L^*$, $a^*$, and $b^*$, comprises a crystal phase having a chemical composition expressed by the following general formula [1], and has a median diameter $D_{50}$ of 15 $\mu$m or more:

$$(Ln_{1-a-b}Ce_aTb_b)_3M_5O_{12} \qquad [1]$$

wherein Ln is at least one element selected from the group consisting of Y, Gd, Sc, Lu, and La, M represents at least one element selected from the group consisting of A1, Ga, and In, and a and b satisfy $0.001 \leq a \leq 0.3$ and $0 \leq b \leq 0.5$, respectively.

14. The phosphor according to Claim 13, wherein the average circularity is 0.86 or more.

15. A method for producing a phosphor according to claim 1, comprising mixing raw materials containing constituent elements, and then firing the mixture, wherein the molar ratio between the charged raw materials satisfies $(5/3) < (M/(Ln_{1-a-b}Ce_aTb_b))$, and the fired product obtained by firing is subjected to washing with acid.

16. The method for producing a phosphor according to Claim 15, wherein at least A1 is contained as M in the general formula [1], and $\alpha$-alumina is used as the Al source.

17. A method for producing the phosphor according to Claim 13, comprising raw materials containing constituent elements, and then firing the mixture, wherein the molar ratio between the charged raw materials satisfies $(5/3) < (M/(Ln_{1-a-b}Ce_aTb_b))$, and the fired product obtained by firing is subjected to washing with acid.

18. The method for producing a phosphor according to Claim 17, wherein at least A1 is contained as M in the general formula [1], and $\alpha$-alumina is used as the raw material of Al.

19. A phosphor-containing composition comprising the phosphor according to Claim 1 and a liquid medium.

20. A light-emitting device comprising a first light emitter which emits light ranging from the ultraviolet to visible region, and a second light emitter which converts the wavelength of at least a portion of light emitted from the first light emitter to emit light in a longer wavelength range than that of the light emitted by the first light emitter, wherein the second light emitter comprises the phosphor according to Claim 1.

21. The light-emitting device according to Claim 20, wherein the first light emitter is a laser diode or a light-emitting diode.

22. An image display device comprising the light-emitting device according to Claim 20 as a light source.

23. A lighting system comprising the light-emitting device according to Claim 20 as a light source.

Fig. 1

Fig. 2

Fig. 3

Fig. 4

Fig. 5

Example 1

Fig. 6

Example 2

Fig. 7

Example 3

Fig. 8

Example 4

Fig. 9

Example 5

Fig. 10

Example 6

Fig. 11

Example 7

Fig. 12

Example 8

Fig. 13

Example 13

EP 1 854 863 A1

**Fig. 14**

Example 17

**Fig. 15**

Example 18

**Fig. 16**

Comparative Example 1

EP 1 854 863 A1

Fig. 17

Comparative Example 3

Variation rate of emission intensity

Wavelength (nm)

Fig. 18

Comparative Example 4

Variation rate of emission intensity

Wavelength (nm)

43

# Fig. 19

<table>
<tr><td colspan="2" align="center"><b>INTERNATIONAL SEARCH REPORT</b></td><td>International application No.<br>PCT/JP2006/303279</td></tr>
</table>

A.  CLASSIFICATION OF SUBJECT MATTER
  *C09K11/62*(2006.01), *C09K11/78*(2006.01), *C09K11/80*(2006.01), *C09K11/08*
  (2006.01), *H01L33/00*(2006.01)

According to International Patent Classification (IPC) or to both national classification and IPC

B.  FIELDS SEARCHED

Minimum documentation searched (classification system followed by classification symbols)
C09K11/08-11/89, H01L33/00

Documentation searched other than minimum documentation to the extent that such documents are included in the fields searched
  Jitsuyo Shinan Koho          1922-1996   Jitsuyo Shinan Toroku Koho   1996-2006
  Kokai Jitsuyo Shinan Koho    1971-2006   Toroku Jitsuyo Shinan Koho   1994-2006

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| A | JP 2002-189080 A  (Hitachi Medical Corp.),<br>05 July, 2002 (05.07.02),<br>Claims; Par. Nos. [0023] to [0036]; examples<br>& EP 1347032 A1        & WO 2002/050211 A1 | 15-18 |
| A | JP 2003-505582 A  (Patent-Treuhand-GmbH),<br>12 February, 2003 (12.02.03),<br>Example 3<br>& WO 2001/008452 A1 | 15-18 |
| A | JP 10-242513 A  (Nichia Chemical Industries,<br>Ltd.),<br>11 September, 1998 (11.09.98),<br>Claims; Par. No. [0033]<br>& AU 3635597 A & CA 2262136 A1 | 1-23 |

| ☒ Further documents are listed in the continuation of Box C. | ☐ See patent family annex. |
|---|---|

*     Special categories of cited documents:
"A"   document defining the general state of the art which is not considered   to
      be of particular relevance
"E"   earlier application or patent but published on or after the international filing
      date
"L"   document which may throw doubts on priority claim(s) or which is
      cited to establish the publication date of another citation or other
      special reason (as specified)
"O"   document referring to an oral disclosure, use, exhibition or other means
"P"   document published prior to the international filing date but later than the
      priority date claimed

"T"   later document published after the international filing date or priority
      date and not in conflict with the application but cited to understand
      the principle or theory underlying the invention
"X"   document of particular relevance; the claimed invention cannot be
      considered novel or cannot be considered to involve an inventive
      step when the document is taken alone
"Y"   document of particular relevance; the claimed invention cannot be
      considered to involve an inventive step when the document is
      combined with one or more other such documents, such combination
      being obvious to a person skilled in the art
"&"   document member of the same patent family

| Date of the actual completion of the international search<br>  10 April, 2006 (10.04.06) | Date of mailing of the international search report<br>  18 April, 2006 (18.04.06) |
|---|---|
| Name and mailing address of the ISA/<br>  Japanese Patent Office | Authorized officer |
| Facsimile No. | Telephone No. |

Form PCT/ISA/210 (second sheet) (April 2005)

**EP 1 854 863 A1**

**INTERNATIONAL SEARCH REPORT**

International application No.

PCT/JP2006/303279

C (Continuation). DOCUMENTS CONSIDERED TO BE RELEVANT

| Category* | Citation of document, with indication, where appropriate, of the relevant passages | Relevant to claim No. |
|---|---|---|
| A | WO 2002/059982 A1 (Nichia Chemical Industries, Ltd.), 01 August, 2002 (01.08.02), Claims; page 20, line 9 to page 21, line 22 & EP 1357610 A1 | 3-4,13 |
| P,A | JP 2005-264062 A (Nemoto & Co., Ltd.), 29 September, 2005 (29.09.05), Claims; Par. Nos. [0005] to [0008]; examples (Family: none) | 15-18 |
| P,X | JP 2005-150691 A (Mitsubishi Chemical Corp.), 09 June, 2005 (09.06.05), Claims; Par. No. [0023] & WO 2005/022032 A1 | 13 |

Form PCT/ISA/210 (continuation of second sheet) (April 2005)

46

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10190066 A
- JP 10247750 A
- JP 10242513 A

- JP 2003505582 A
- JP 2003505583 A
- JP 2005053676 A